# EUROPEAN PATENT SPECIFICATION

(11) **EP 4 265 575 B1**
(45) Date of publication and mention of the grant of the patent: **14.05.2025**
(21) Application number: 23169207.0
(22) Date of filing: 21.04.2023
(51) Int. Cl.: C03C 17/00, C03C 21/00, C03C 3/085, B60K 35/00, B60K 35/22

(54) **GLASS ARTICLES COMPRISING SELECTIVELY PATTERNED OPAQUE LAYERS FOR LIGHT SENSORS AND DISPLAY SYSTEMS COMPRISING THE SAME**
GLASARTIKEL MIT SELEKTIV STRUKTURIERTEN OPAKEN SCHICHTEN FÜR LICHTSENSOREN UND ANZEIGESYSTEME DAMIT
ARTICLES EN VERRE COMPRENANT DES COUCHES OPAQUES À MOTIFS SÉLECTIFS POUR CAPTEURS DE LUMIÈRE ET SYSTÈMES D'AFFICHAGE LES COMPRENANT

(30) Priority: 21.04.2022 US 202263333231 P
(43) Date of publication of application: 25.10.2023
(73) Proprietor: Corning Incorporated, Corning, New York 14831 (US)
(72) Inventor: LI, Xinghua, Horseheads, 14845 (US); SUN, Yawei, Elmira, 14903 (US)
(74) Representative: Epping - Hermann - Fischer

(56) References cited:
- US-A1- 2012 170 284
- US-A1- 2019 317 258
- US-A1- 2022 059 050
- US-B2- 10 146 996

## Description

### FIELD

The disclosure relates to glass articles comprising opaque layers that are selectively patterned to provide regions of relatively high optical transmission at a sensing wavelength associated with a sensor, and display systems comprising the same.

### BACKGROUND

In various applications involving displays, it is desirable to employ an ambient light sensor to provide various inputs that may be used to control operation of the display. When an amount of ambient light detected by the ambient light sensor increases, for example, a display may be operated with increased brightness to improve the visibility of the image. One context where such ambient light sensors may find use is for automotive interiors, where ambient lighting conditions can vary dramatically depending on location and time of day.

It is generally beneficial to position an ambient light sensor near a display that is controlled by the ambient light sensor so that the sensor measures an accurate representation of the lighting conditions encountered by the display. For example, it may be beneficial to position an ambient light sensor behind a cover glass associated with the display. While beneficial from a display control perspective, such positioning of the ambient light sensor may adversely affect the appearance of the display. For example, the ambient light sensor may be visible to viewers when positioned behind the cover glass if additional measures are not taken to conceal the appearance of the sensor. Existing approaches for concealing sensors may employ a semi-transparent ink layer that is screen printed onto the cover glass. The semi-transparent ink layer may reduce the optical transmission of the cover glass to a great enough extent to conceal visibility of the ambient light sensor, while still having a high enough transmittance to facilitate operation of the ambient light sensor. However, such semi-transparent ink layers are generally screen printed onto the cover glass, which adds complexity and cost to the manufacturing process.

Accordingly, an alternative process for concealing sensors used with displays is desired.

### SUMMARY

The present disclosure pertains to a glass article comprising: a glass substrate having a first major surface and a second major surface, the second major surface being opposite the first major surface; and an opaque layer disposed on the second major surface, wherein: the opaque layer comprises an optical density of greater than 3.0 such that portions of the glass substrate covered by the opaque layer comprise an average optical transmission of less than or equal to 0.5% for light from 400 nm to 700 nm, within a sensor region of the glass article, the opaque layer comprises a plurality of ablated portions, and an average optical transmission of the glass article within the sensor region is greater than or equal 1.0% for the light from 400 nm to 700 nm as a result of the plurality of ablated portions.

It is to be understood that both the foregoing general description and the following detailed description are merely exemplary, and are intended to provide an overview or framework to understanding the nature and character of the claims. The accompanying drawings are comprised to provide a further understanding, and are incorporated in and constitute a part of this specification. The drawings illustrate one or more embodiment(s), and together with the description serve to explain principles and operation of the various embodiments.

### BRIEF DESCRIPTION OF THE DRAWINGS

The accompanying drawings incorporated in and forming a part of the specification illustrate several aspects of the present invention and, together with the description, serve to explain the principles of the invention. In the drawings:
FIG. 1 is a perspective view of a vehicle interior with a vehicle display system, according to one or more embodiments of the present disclosure;
FIG. 2A schematically depicts a cross-sectional view of a display of a vehicle interior display system through the line II-II in FIG. 1, according to one or more embodiments of the present disclosure;
FIG. 2B schematically depicts a plan view of the glass article depicted in FIG. 2A, according to one or more embodiments of the present disclosure;
FIG. 2C schematically depicts an array of ablated portions of an opaque layer associated with the glass article depicted in FIGS. 2A and 2B, according to one or more embodiments of the present disclosure;
FIG. 3A depicts a flow diagram of a method of fabricating a display system, according to one or more embodiments of the present disclosure;
FIG. 3B depicts an apparatus that may be used to form an array of ablated portions in an opaque layer of a glass article, according to one or more embodiments of the present disclosure;
FIG. 4A depicts a first example array of ablated portions in an opaque layer formed with a CO₂ laser, according to one or more embodiments of the present disclosure;
FIG. 4B depicts a second example array of ablated portions in an opaque layer formed with an ultraviolet laser, according to one or more embodiments of the present disclosure;
FIG. 5A depicts an example ablated portion formed with a CO₂ laser, according to one or more embodiments of the present disclosure;
FIG. 5B depicts an example ablated portion formed with an ultraviolet laser, according to one or more embodiments of the present disclosure;
FIG. 5C depicts an example ablated portion formed with an infrared laser, according to one or more embodiments of the present disclosure;
FIG. 6A depicts an example array of ablated portions in an opaque layer wherein, within each ablated portion, the opaque layer is completely removed from a glass article, according to one or more embodiments of the present disclosure;
FIG. 6B depicts an example array of ablated portions in an opaque layer wherein, within each ablated portion, the opaque layer is not completely removed from a glass article, according to one or more embodiments of the present disclosure; and
FIG. 7 schematically depicts a substrate, according to one or more embodiments of the present disclosure.

### DETAILED DESCRIPTION

Referring generally to the figures, described herein are embodiments of glass articles comprising opaque layers that are selectively ablated to include an array of ablated portions that are regions of elevated optical transmission of the glass article. In the regions of elevated optical transmission, the glass article may transmit light in a wavelength range of interest associated with a sensor positioned proximate to the glass article. For example, in embodiments, the regions of elevated optical transmission may provide an average optical transmission of greater than or equal to 1% (e.g., greater than or equal to 5% greater than or equal to 10%, greater than or equal to 15%, greater than 20%) over the visible spectrum (e.g., from 400 nm to 700 nm) such that the sensor can detect a relative intensity of visible light incident on the glass article (e.g., when the sensor is an ambient light sensor). In embodiments, the opaque layer may comprise a relatively high optical density (e.g., greater than 3.0 or greater than or equal to 4.0 or greater than or equal to 5.0) and therefore substantially block visible light from propagating through the glass article. The opaque layer may be used to conceal various components associated with the glass article from view, while the array of ablated portions permits a sufficient amount of light through the glass article to permit detection by the sensor.

In aspects, the array of ablated portions may be structured to conceal the appearance of the sensor, while still providing sufficient optical transmittance to facilitate operation of the sensor. In embodiments, for example, the array of ablated portions extends over a sensor region of the glass article that overlaps the sensor. In embodiments, when the array of ablated portions comprises a plurality of ablated portions (i.e., more than or ablated portion), the array of ablated portions is structured (e.g., arranged, spaced, sized) such that at least 50% (e.g., at least 55%, at least 60%, at least 65%, at least 70%, at least 75%, at least 80%) of the glass substrate in the sensor region is still covered by the opaque layer. Put differently, within the sensor region, less than or equal to 50% (e.g., less than or equal to 45%, less than or equal to 40%, less than or equal to 35%, less than or equal to 30%, less than or equal to 25%, less than or equal to 20%) of the opaque layer is ablated via the processes described herein. The ablated portions may also be sized to have a maximum horizontal dimension (measured in a direction parallel to a major surface of the glass substrate) that is less than or equal to 100 µm (e.g., less than or equal to 90 µm, less than or equal to 80 µm, less than or equal to 70 µm, less than or equal to 60 µm, less than or equal to 50 µm, less than or equal to 40 µm, less than or equal to 35 µm). The array of ablated portions may also comprise a minimum edge-to-edge separation distance separating adjacent ablated portions that is greater than (e.g., at least 1.25 times greater than, at least 1.5 times greater than, at least 2.0 times greater than, at least 2.5 times greater than, at least 3.0 times greater than) the maximum horizontal dimension of the ablated portions. Such limited size of the ablated portions, in conjunction with the spacing therebetween, aids in concealing the sensor via the remaining opaque layer contained in the sensor region.

In aspects, the array of ablated portions in the opaque layer described herein may be formed using any suitable laser process. In embodiments, the opaque layer is absorptive of light ranging from the ultraviolet ("UV") to ("IR") spectra. For example, in embodiments, the opaque layers described herein may be formed of a suitable epoxy, acrylic, polyurethane, or latex paint or ink. As such, any suitable laser source emitting light in that wavelength range may be used to ablate the opaque layer by selectively heating portions of the opaque layer to a great enough extent to remove material of the opaque layer from select regions of the glass article. Any laser source (e.g., pulsed laser source, continuous wave laser source) capable of generating light above the material of the opaque layer's ablation threshold may be used. Moreover, various suitable mechanisms for providing relative movement between the glass article and laser beam (e.g., movement of the glass substrate relative to the laser source, a scanning optical system for moving the laser beam relative to the glass substrate, or a combination thereof) are contemplated and within the scope of the present disclosure. Existing laser marking systems may be employed to create the array of ablated portions. As such, the array of ablated portions described herein facilitates operation of sensors (e.g., ambient wavelength sensors) from behind the glass articles, while still concealing the sensors from view, without the use of additional semitransparent films or ink layers. The glass articles of the present disclosure facilitate sensor incorporation with minimal impact on the appearance of the display.

As used herein, the terms "optical transmission" and "percent transmission" or "transmittance" are used interchangeably and refer to a percentage of light transmitted through an article over a wavelength range of interest. An "average optical transmission" for light in a particular wavelength range is determined by averaging a measured optical transmission at all of the whole number wavelengths within that wavelength range. Unless otherwise noted herein, average optical transmission values are for ambient light incident on the entire article, which may be approximated with a CIE D65 illuminant.

As used herein, unless otherwise stated, the term "visible spectrum" refers to a wavelength range of 400 nm to 700 nm.

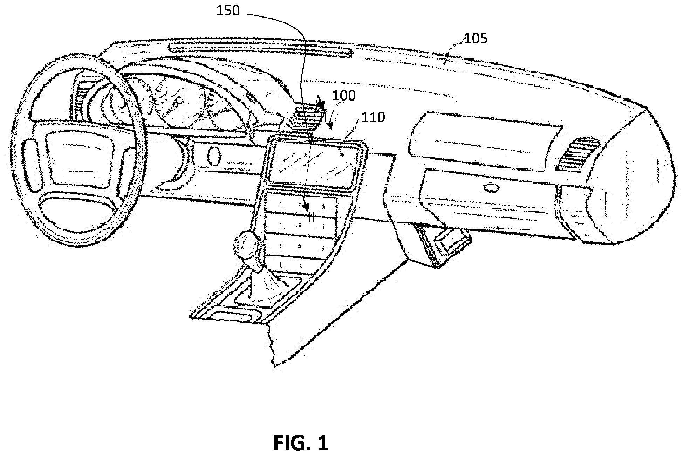

FIG. 1 depicts a vehicle display system 100 comprising a display 110, according to an example embodiment. The vehicle display system 100 can be incorporated into vehicles such as trains, automobiles (e.g., cars, trucks, buses and the like), seacraft (e.g., boats, ships, submarines, and the like), and aircraft (e.g., drones, airplanes, jets, helicopters and the like), including both human-piloted vehicles, semi-autonomous vehicles and fully autonomous vehicles. The vehicle display system 100 includes a vehicle base 105, such as a center console, a dashboard, or a steering wheel of a vehicle. In embodiments, the vehicle base 105 may include various other vehicle portions, such as an arm rest, a pillar, a seat back, a floorboard, a headrest, a door panel, or any portion of the interior of a vehicle. While the description herein relates primarily to the use of the glass articles in vehicle displays, it should be understood that various embodiments discussed herein may be used in any type of display application. The present disclosure is also not limited to display applications, but could be used in any application incorporating a light source and sensor in close proximity to one another where a uniform appearance is desired.

In embodiments, the vehicle display system 100 can be integrated with the electronics system of the vehicle, or the vehicle display system 100 may be separate therefrom. The display 110 may be manufactured as part of the vehicle or may be retrofitted. In embodiments, the display 110 is attached to a suitable support structure that is mounted on the vehicle base 105. In embodiments, a rear surface of the display 110 may be in contact with the support structure such that a front, user-facing surface of the display 110 (e.g., corresponding to the first major surface 470 described herein) faces the vehicle interior so that an image on the display 110 can be viewed by vehicle occupants. In embodiments, the display 110 may be positioned so as to form a portion of the vehicle base 105 and may follow the shape and contour thereof.

A variety of constructions of the display 110 are contemplated and within the scope of the present disclosure. As shown in FIG. 1, for example, the display 110 is incorporated into the vehicle base 105 that is a center console. The display 110 can be flat or curved depending on the implementation. In embodiments, the display 110 comprises a glass substrate, such as a cold-bent glass substrate or a flat glass substrate, and a display module, which may include a backlight unit and a second glass substrate. Curved embodiments incorporating a cold-formed glass substrate may be formed utilizing any of the techniques described in U.S. Pre-Grant Publication No. 2019/0329531 A1, entitled "Laminating thin strengthened glass to curved molded plastic surface for decorative and display cover application," U.S. Pre-Grant Publication No. 2019/0315648 A1, entitled "Cold-formed glass article and assembly process thereof," U.S. Pre-Grant Publication No. 2019/0012033 A1, entitled "Vehicle interior systems having a curved cover glass and a display or touch panel and methods for forming the same," and U.S. Pre-Grant Publication No. 2021/0308986 A1, entitled "Curved glass constructions and methods for forming same,". In embodiments, the display 110 is a flexible display capable of being manipulated in shape and/or position, as described in U.S. Pre-Grant Publication No. 2022/0020304 A1, entitled "Dynamically Adjustable Display System and Methods of Dynamically Adjusting a Display,".

As shown in FIG. 1, the vehicle display system 100 comprises a sensor 150. The sensor 150 is disposed proximate to the display 110. In embodiments, the sensor 150 is used by a control system (not depicted) associated with the vehicle display system 100 to control operation of the display 110. In embodiments, the sensor 150 comprises a photodetector configured to generate electrical signals responsive to light being incident thereon. In such embodiments, the sensor 150 may be used to detect light that is incident on the display to determine an ambient light state. At times when the ambient light is detected to be relatively high, for example, the control system (e.g., via a processor executing instructions stored in a memory) may increase a brightness of an image generated by the display 110 to render the image more visible to viewers in the vehicle interior. Such dynamic brightness adjustment beneficially renders the image viewable by the viewers irrespective of the ambient light state in the vehicle interior.

In embodiments, the sensor 150 detects light in a suitable wavelength range of interest to determine the ambient light state. For example, in embodiments, the sensor 150 may measure light throughout the visible spectrum (e.g., from 400 nm to 700 nm) to determine whether the ambient light conditions are likely to generate glare on the display 110. Embodiments where the sensor 150 generates signals responsive to light in other wavelength ranges of interest (e.g., detects light outside of the visible spectrum) are also contemplated and within the scope of the present disclosure. Moreover, while the example of a photodetector has been described herein, the sensor 150 may be employed in a variety of forms (e.g., a location detector, a camera, a proximity sensor). While the depicted example only includes a single sensor 150, embodiments are also contemplated that incorporate more than one sensor.

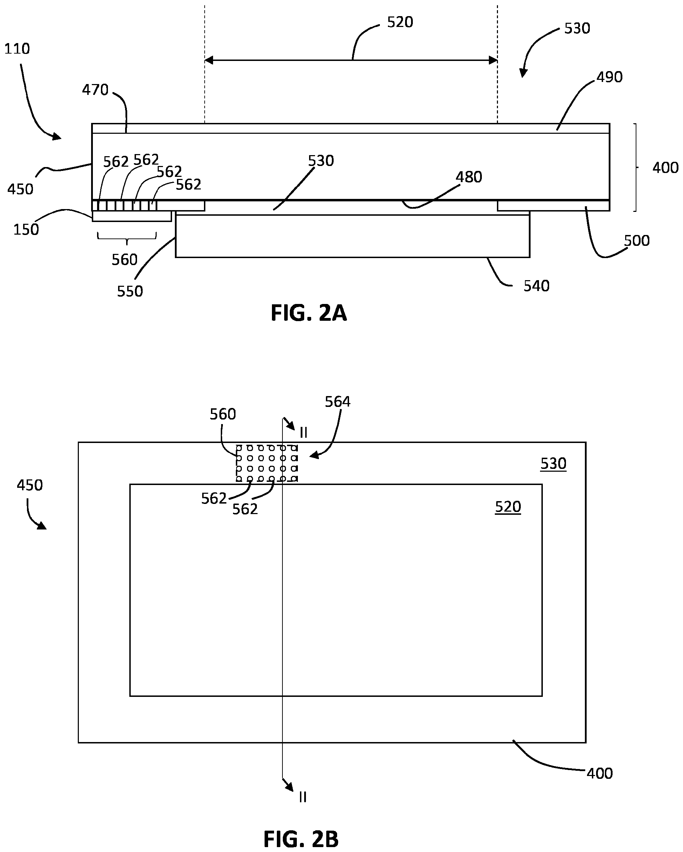

In embodiments, the sensor 150 is positioned behind a cover glass associated with the display 110. For example, FIG. 2A schematically depicts a cross-sectional view of the display 110 through the line II-II depicted in FIGS. 1 and 2A, according to an example embodiment. As shown, the display 110 generally comprises a glass article 400 and a display module 540. In embodiments the display module 540 comprises a light source configured to generate light that is transmitted through the glass article 400 for providing information to viewers in the vehicle interior. In one or more embodiments, the display module 540 comprises a display, such as a touch-enabled display which includes a display and touch panel. Exemplary displays include LED display, a DLP MEMS chip, LCDs, OLEDs, transmissive displays, and the like. Alternatively or additionally, the display module 540 comprises another suitable light emission device (e.g., a light-emitting diode or light-emitting diode array, a laser, or other light source). The glass article 400 generally serves as a cover glass for the display module 540 providing protection and other performance enhancing attributes (e.g., anti-glare or anti-reflective) thereto.

The sensor 150 is shown to be disposed behind the glass article 400 and proximate to the display module 540. Such a structure is beneficial in that the sensor 150 is able to detect environmental conditions that accurately represent what the display 110 is exposed to (see FIG. 1) in real-time. Moreover, the glass article 400 also serves as a protective cover for the sensor 150 and conceals the sensor 150 from view via the methods described herein.

As shown in FIG. 2A, the glass article 400 comprises at least a substrate 450 and an opaque layer 500. The substrate 450 has a first major surface 470 facing a viewer and a second major surface 480 upon which the opaque layer 500 may be disposed (at least in part). As used herein, the term "dispose" includes coating, depositing and/or forming a material onto a surface using any known method in the art. The disposed material may constitute a layer, as defined herein. As used herein, the phrase "disposed on" includes the instance of forming a material onto a surface such that the material is in direct contact with the surface and also includes the instance where the material is formed on a surface, with one or more intervening material(s) is between the disposed material and the surface. The intervening material(s) may constitute a layer, as defined herein. The term "layer" may include a single layer or may include one or more sub-layers. Such sub-layers may be in direct contact with one another. The sub-layers may be formed from the same material or two or more different materials. In one or more alternative embodiments, such sub-layers may have intervening layers of different materials disposed therebetween. In one or more embodiments a layer may include one or more contiguous and uninterrupted layers and/or one or more discontinuous and interrupted layers (i.e., a layer having different materials formed adjacent to one another). A layer or sub-layers may be formed by any known method in the art, including discrete deposition or continuous deposition processes. In one or more embodiments, the layer may be formed using only continuous deposition processes, or, alternatively, only discrete deposition processes.

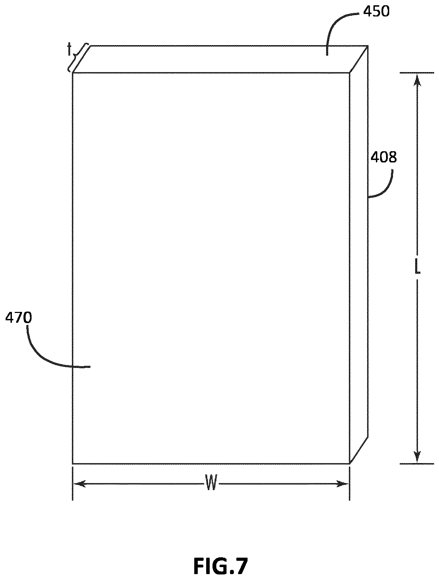

In embodiments, the substrate 450 is a glass substrate that is optionally chemically strengthened and comprises a thickness of from 0.05 to 2.0 mm. More detail on the construction of such a glass substrate will be provided herein with respect to FIG. 7. In embodiments, the substrate 450 may be a transparent plastic, such as PMMA, polycarbonate and the like.

In embodiments, the glass article 400 comprises a functional surface layer 490. The functional surface layer 490 can be configured to provide one or more of a variety of functions. For example, the functional surface layer 490 may be optical coating configured to provide easy-to-clean performance, anti-glare properties, antireflection properties, and/or half-mirror coating. Such optical coatings can be created using single layers or multiple layers. In the case of anti-reflection functional surface layers, such layers may be formed using multiple layers having alternating high refractive index and low refractive index. Non-limiting examples of low refractive index films include SiO₂, MgF₂, and Al₂O₃, and non-limiting examples of high refractive index films include Nb₂O₅, TiO₂, ZrO₂, HfO₂, and Y₂O₃. In embodiments, the total thickness of such an optical coating (which may be disposed over an anti-glare surface or a smooth substrate surface) is from 5 nm to 750 nm. Additionally, in embodiments, the functional surface layer 490 that provides easy-to-clean performance also provides enhanced feel for touch screens and/or coating/treatments to reduce fingerprints. In some embodiments, functional surface layer 490 is integral to the first surface of the substrate. For example, such functional surface layers can include an etched surface in the first surface of the substrate 450 providing an anti-glare surface (or haze of from, e.g., 2% to 20%).

In embodiments, the opaque layer 500 is printed onto the second major surface 480 of the substrate 450. The opaque layer 500 may be constructed of a suitable ink (e.g., photocurable ink a thermally curable ink), such that the opaque layer 500 possesses a relatively high optical density (e.g., an optical density of greater than 3 or greater than or equal to 4), in order to block light transmittance. In embodiments, the opaque layer 500 is constructed of a suitable ink comprising a pigment dispersion (e.g., containing a suitable colorant such as carbon black and monomers) and binder solution. Various commercially available photocurable and radiation-curable inks are contemplated and within the scope of the present disclosure. The ink used to form the opaque layer 500 may generally absorb radiation from the UV spectrum through the infrared spectrum.

In embodiments, the opaque layer 500 is used to block light from transmitting through certain regions of the glass article 400. In embodiments, the opaque layer 500 obscures functional or non-decorative elements provided for the operation of the glass article 400. In embodiments, the opaque layer 500 is provided to outline backlit icons and/or other graphics (not depicted) so as to increase the contrast at the edges of such icons and/or graphics. The opaque layer 500 can be any color; in particular embodiments, though, the opaque layer 500 is black or gray. In embodiments, the opaque layer 500 is applied via a suitable application technique (e.g., inkjet printing, screen printing) over the second major surface 480 of the substrate 450. Generally, the thickness of the opaque layer 500 is less than or equal to 25 µm (e.g., greater than or equal to 1.0 µm and less than or equal to 25.0 µm, greater than or equal to 5.0 µm and less than or equal to 25.0 µm, greater than or equal to 5.0 µm and less than or equal to 20.0 µm, greater than or equal to 5.0 µm and less than or equal to 10.0 µm).

In embodiments, the opaque layer 500 is directly deposited onto the second major surface 480. In embodiments, prior to deposition of the opaque layer 500, the second major surface 480 may be primed using a suitable primer (e.g., an acryloxy silane primer) to facilitate adhesion of the opaque layer 500 to the substrate 450. Any suitable treatment to the second major surface 480 may be used to facilitate adhesion of the opaque layer 500 to the substrate 450.

**In** embodiments, the high optical density of the opaque layer 500 causes the areas of the glass article 400 incorporating the opaque layer 500 to have relatively low average optical transmission (e.g., an average transmittance of less than or equal to 0.5% or less than or equal to 0.1%) in the visible spectrum. Accordingly, the boundaries of the opaque layer 500 may define an image region 520, where the glass article 400 can exhibit a relatively high optical transmission (e.g., greater than or equal to 50%, 60%, 70%, 80%, or 90%, averaged over the visible spectrum) to facilitate visibility of the light generated by the display module 540, and a peripheral region 530, where the glass article 400 generally exhibits a lower optical transmission than in the image region 520 to facilitate concealment of various components. In the depicted embodiment, the opaque layer 500 covers the edges 550 of the display module 540 to hide the edges 550 from view through the first major surface 470. The opaque layer 500 may also be used to obscure various other components from view (e.g., electrical connections, mechanical housings, and the like). The opaque layer 500 generally facilitates a desired portion of the display module 540 being viewable by users viewing the first major surface 470.

Referring still to FIG. 2A, the opacity and high optical density of the opaque layer 500 may hinder operation of the sensor 150 by preventing light in the wavelength range of interest from reaching the sensor 150. Accordingly, within a sensor region 560 of the glass article 400, portions of the opaque layer 500 are selectively removed (at least partially) to provide regions of relatively high optical transmission (as compared with portions of the glass article 400 where no portion of the opaque layer 500 is removed) in the wavelength range of interest associated with the sensor 150. As a result of such selective removal of the opaque layer 500, the opaque layer 500 comprises a plurality of ablated portions 562 in the sensor region 560. In embodiments, within each of the plurality of ablated portions 562, at least some of the material of the opaque layer 500 is removed such that the opaque layer 500 comprises a diminished thickness within the plurality of ablated portions 562. In embodiments, all of the material of the opaque layer 500 is removed within each of the plurality of ablated portions 562, such that, within each of the plurality of ablated portions 562, the opaque layer 500 is completely devoid of the material making up the remainder of the opaque layer 500. The plurality of ablated portions 562 may comprise voids devoid of the material (e.g., cured ink) of the opaque layer 500. In embodiments, the plurality of ablated portions 562 are filled with air or other gas that is a component of the external environment of the display 110. In embodiments, the plurality of ablated portions 562 may be at least partially filled with another material (e.g., an optically clear adhesive used to attach the sensor 150 or other component such as a support structure).

In embodiments, the plurality of ablated portions 562 in the opaque layer 500 contain less of the material that tends to absorb optical radiation in the wavelength range of interest associated with the sensor 150 that makes up a remainder of the opaque layer 500. As a result, within the plurality of ablated portions 562, the glass article 400 comprises a higher optical transmission within the wavelength range of interest than in other portions of the glass article 400 where the opaque layer 500 comprises a full thickness. The plurality of ablated portions 562 comprise regions of elevated optical transmission in the wavelength range of interest, thereby allowing a detectable amount of radiation to propagate through the glass article 400 within the sensor region 560 to reach the sensor 150 to generate a sensor signal that can be used to estimate the ambient light state of the display 110 and control the display module 540 accordingly.

FIG. 2B schematically depicts a plan view of the glass article 400 (e.g., from the side of the first major surface 470), according to an example embodiment of the present disclosure. In the depicted embodiment, the image region 520 defined at least in part by the opaque layer 500, is rectangular-shaped (e.g., to correspond to an image generated by the display module 540 depicted in FIG. 2A). The peripheral region 530, corresponding to the portion of the glass substrate 450 that is covered by the optically absorptive material of the opaque layer 500, circumferentially surrounds the image region 520. In embodiments, the peripheral region 530 extends radially inward from an outer peripheral edge of the glass substrate 450 to an inner edge of the opaque layer 500 defining an outer boundary of the image region 520. The particular shape and size of the image region 520 and the peripheral region 530 are not particularly limiting.

In the depicted embodiment, the sensor region 560 is contained in the peripheral region 530. The sensor region 560 corresponds to the smallest shape extending tangent to all of the outermost ablated portions in the plurality of ablated portions 562. The outermost ablated portions comprise geometric centers that are the greatest radial distance from the geometric center of the plurality of ablated portions 562 when viewed as a whole (e.g., a geometric center of the array of ablated portions 564, see FIG. 2B). In embodiments, the sensor region 560 corresponds in shape and size to a sensing area of the sensor 150 (see FIG. 2A). The size and shape of the sensor region 560 may correspond in shape to a particular area over which the sensor 150 may detect radiation (e.g., corresponding to the size of a photodetector or photodetector array, or a sensing area determined by optics within the sensor 150). Such a construction is beneficial in that the plurality of ablated portions 562 are arranged over the entire sensing area of the sensor 150, facilitating detection over a wide area and favorable sensitivity over embodiments where the sensor region 560 is smaller than the overall sensing area. Embodiments are also envisioned where the sensor region 560 is smaller or greater in size than the sensor 150. In embodiments, a surface area of the sensor region may be greater than or equal to 200 µm² (e.g., greater than or equal to 300 µm², greater than or equal to 500 µm², greater than or equal to 600 µm², greater than or equal to 700 µm², greater than or equal to 800 µm², greater than or equal to 200 µm² and less than or equal to 4000 µm²), for example, when the sensor region 560 only comprises a single ablated portion. In embodiments, for example, when the sensor region comprises a plurality of ablated portions, a surface area of the sensor region is greater than or equal to 1 mm² (e.g., greater than or equal to 1.5 mm², greater than or equal to 2.0 mm², greater than or equal to 2.5 mm², or even greater) and less than or equal to 400 mm² (e.g., less than or equal to 300 mm², less than or equal to 200 mm², less than or equal to 100 mm², less than or equal to 50 mm²). Sensor regions that are greater in size than any of the preceding ranges are also contemplated and within the scope of the present disclosure.

In embodiments, the plurality of ablated portions 562 comprises at least 1 (e.g., at least 2, at least 3, at least 4, at least 6, at least 6, at least 7, at least 8, at least 9, at least 10, at least 12, at least 14, at least 16, at least 18, at least 20, at least 22, at least 24, at least 26, at least 28, at least 30, at least 40, at least 50) separate ablated portions of the opaque layer 500. The plurality of ablated portions 562 are generally arranged in an array of ablated portions 564. The array of ablated portions 564 may contain any suitable arrangement of ablated portions. For example, in the depicted embodiment, the array of ablated portions 564 comprises a plurality of equally spaced rows of ablated portions, with each row of ablated portions comprising a plurality of equally spaced ablated portions. Such an arrangement uniformly distributes the ablated portions over the sensor region 560 and may facilitate consistent measurements by the sensor 150. Other arrangements, where the ablated portions are distributed non-uniformly or in other patterns, are also contemplated and within the scope of the present disclosure. In embodiments, for example, the array of ablated portions 564 is arranged in an alternating row arrangement, where every other row of ablated portions is aligned in a direction extending perpendicular to the row direction, but adjacent rows are offset from one another along the row direction. Any suitable pattern of ablated portions is possible and may be fabricated in accordance with the method described herein.

The array of ablated portions 564 is constructed so that, within the sensor region 560, the glass article 400 comprises an average optical transmission of greater than or equal to 0.5% (e.g., greater than or equal to 1.0%, greater than or equal to 1.5%, greater than or equal to 2.0%, greater than or equal to 2.5%, greater than or equal to 3.0%, greater than or equal to 3.5%, greater than or equal to 4.0%, greater than or equal to 4.5%, greater than or equal to 5.0%, greater than or equal to 6.0%, greater than or equal to 7.0%, greater than or equal to 8.0%, greater than or equal to 9.0%, greater than or equal to 10%, greater than or equal to 12%, greater than or equal to 14%, greater than or equal to 16%, greater than or equal to 18%, greater than or equal to 19%) in the wavelength range of interest associated with the sensor 150. Such an optical transmission allows the sensor 150 to provide usable detection signals (e.g., above a signal-to-noise ratio associated with the sensor 150) from light propagating through the glass article 400. In embodiments, the array of ablated portions 564 is constructed so that, within the sensor region 560, the glass article 400 comprises an optical average transmission of less than or equal to 25% (e.g., less than or equal to 24%, less than or equal to 23%, less than or equal to 22%, less than or equal to 21%, less than or equal to 20%, less than or equal to 19%, less than or equal to 18%, less than or equal to 17%, less than or equal to 15%, less than or equal to 14%, less than or equal to 13%, less than or equal to 12%, less than or equal to 11%, less than or equal to 10%) in the visible spectrum to aid in concealing the sensor 150 from view. As such, in embodiments, within the sensor region 460, the glass article 400 may comprise an average optical transmission in the visible spectrum (e.g., from 400 nm to 700 nm) that is greater than or equal to 0.5% and less than or equal to 25% (e.g., greater than or equal to 1% and less than or equal to 20%, greater than or equal to 2% and less than or equal to 20%, greater than or equal to 3% and less than or equal to 20%, greater than or equal to 4% and less than or equal to 20%, greater than or equal to 5% and less than or equal to 20%). Such an optical transmission facilitates operation of the sensor 150 while still concealing the sensor 150 from view when the display 110 is viewed from the interior of the vehicle.

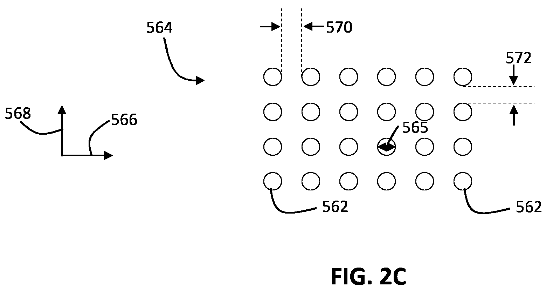

To provide such an optical transmission, the ablated portions in the opaque layer 500 may be constructed with a size and spacing such that a majority of the surface area of the opaque layer 500 in the sensor region 560 does not contain an ablated portion. In embodiments, when, for example, the array of ablated portions 564 comprises more than one ablated portion, a combined surface area of the plurality of ablated portions 562 makes up less than 50% (e.g., less than 45%, less than 40%, less than 35%, less than 30%, less than 25%, less than 10%) of the surface area of the sensor region 560, measured in a direction extending parallel to the second major surface 480 of the glass substrate 450 (see FIG. 2A). The greater the combined surface area percentage of the plurality of ablated portions 562, the higher optical transmission in the wavelength range of interest and/or visible spectrum. As such, the manner with which the array of ablated portions 564 is constructed may vary depending on the construction of the display 110. When the sensor 150 tends to be more reflective of light, for example, the combined surface area percentage of the plurality of ablated portions 562 may generally be on the lower end of the above range (e.g., less than 30%, less than 25%, less than 10%) to aid in hiding the sensor. The combined surface area percentage of the plurality of ablated portions 562 may also vary depending on the sensitivity of the sensor 150 (e.g., more sensitive detection circuitry may allow smaller ablated portions that are spaced apart at greater distances from one another to aid in hiding the sensor 150 from view). FIG. 2C schematically depicts the array of ablated portions 564 in greater detail. In the depicted embodiment, each ablated portion of the plurality of ablated portions 562 is the same shape. Such a structure may facilitate efficient realization of the ablated portions by allowing consistent laser operation parameters in forming the ablated portions, as described herein. Embodiments are also contemplated where the ablated portions vary from one another in size and shape, though such embodiments may disadvantageously require more complicated laser control regimes during the methods described herein.

In the depicted embodiment, each ablated portion in the plurality of ablated portions 562 is substantially circular in shape. The shape of the ablated portions may generally correspond in shape to the spatial intensity density distribution of a laser beam that is used to form the plurality of ablated portions 562. The shape of the spatial intensity distribution at which the laser beam possesses an intensity above the material of the opaque layer 500's ablation threshold generally determines the shape and size of the ablated portions. As may be appreciated, the actual shape of the ablated portions may vary somewhat from being precisely circular due to laser variations and the ablation process. In embodiments, each ablated portion of the plurality of ablated portions 562 comprises a maximum horizontal dimension 565, measured in a direction extending parallel to the second major surface 480 of the glass substrate 450 (see FIG. 2A), that is less than or equal to 100 µm (e.g., less than or equal to 90 µm, less than or equal to 80 µm, less than or equal to 70 µm, less than or equal to 60 µm, less than or equal to 50 µm, less than or equal to 40 µm, less than or equal to 30 µm, less than or equal to 20 µm). The maximum horizontal dimension corresponds to a length of a longest straight light extending through one of the ablated portions and connecting two different portions of a perimeter edge of one of the ablated portions. Maintaining the maximum horizontal dimension 565 beneath 100 µm facilitates rendering them invisible to the naked eye and provides the display 110 with a favorable appearance.

As shown in FIG. 2C, the array of ablated portions 564 comprises a plurality of rows of ablated portions extending along a first direction 566. The plurality of rows are spaced apart along a second direction 568. Adjacent ablated portions in each row may comprises a minimum first direction edge-to-edge distance 570 that is greater than or equal to the maximum horizontal dimension 565 of each ablated portion. In embodiments, the minimum first direction edge-to-edge distance 570 is greater than or equal to 0.9 times (e.g., greater than or equal to 1.0 times, greater than or equal to 1.1 times, greater than or equal to 1.2 time, greater than or equal to 1.3 times, greater than or equal to 1.4 times, greater than or equal to 1.5 times, greater than or equal to 1.6 times, greater than or equal to 1.7 times, greater than or equal to 1.8 times, greater than or equal to 1.9 times, greater than or equal to 2.0 times) the maximum horizontal dimension 465. Adjacent rows in the array of ablated portions 564 may also be separated from one another such that ablated portions that are nearest to one another in the second direction 568 comprise a minimum second direction edge-to-edge distance 572 that is greater than or equal to the maximum horizontal dimension 565 of each ablated portion. In embodiments, for example, the minimum second direction edge-to-edge distance 572 is greater than or equal to 0.9 times (e.g., greater than or equal to 1.0 times, greater than or equal to 1.1 times, greater than or equal to 1.2 time, greater than or equal to 1.3 times, greater than or equal to 1.4 times, greater than or equal to 1.5 times, greater than or equal to 1.6 times, greater than or equal to 1.7 times, greater than or equal to 1.8 times, greater than or equal to 1.9 times, greater than or equal to 2.0 times) the maximum horizontal dimension 465. Generally, regardless of the exact arrangement of the ablated portions, the ablated portions are arranged such that a minimum edge-to-edge separation distance (measuring a length of a line extending parallel to the second major surface 480 separating a pair of ablated portions that are closest to one another) is greater than or equal to the 0.9 times the maximum horizontal dimension 465. Such spacing of the ablated portions facilitates the presence of the opaque layer 500 concealing the sensor 150 from view.

While the array of ablated portions 564 comprises a rectangular peripheral shape of evenly spaced rows of ablated portions, it should be understood that a variety of arrangements of ablated portions are contemplated and within the scope of the present disclosure. Any suitable combination of ablated portions, having any suitable size or peripheral shapes, are contemplated and within the scope of the present disclosure. Since the ablated portions described herein may be formed through laser ablation of the opaque layer 500, the arrangement of ablated portions can be tailored specifically to use case needs through manipulation of laser parameters.

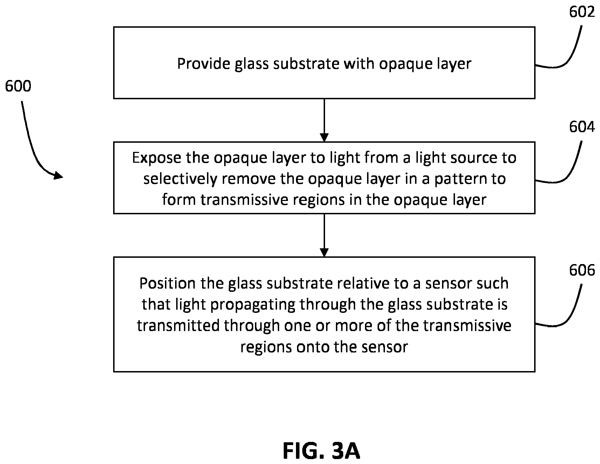

FIG. 3A depicts a flow diagram of a method 600 of fabricating a display system comprising an ambient light sensor, according to an example embodiment of the present disclosure. In an example, the method 600 may be used to fabricate the glass article 400 and/or display 110 described herein with respect to FIGS. 1-2C. The method 600 may also be used to fabricate other glass articles. Reference will be made to various components of the display 110, as described herein with respect to FIGS. 1-2C, to aid in the description of the method 600.

At block 602, the glass substrate 450 is provided with the opaque layer 500 disposed thereon. The glass substrate 450 may be fabricated via any suitable method (e.g., float method, down-draw method) or purchased commercially. The opaque layer 500 may be formed by depositing a suitable curable ink (e.g., a thermally cured ink or radiation-curable ink) comprising, for example, a pigment dispersion, binder system, and photoinitiator. The pigment dispersion may contain a suitable colorant (e.g., carbon black) at a relatively high weight percentage (e.g., at least 10 wt%, at least 20 wt%, at least 30 wt%) such that the ink, once cured, provides an optical density of greater than or equal to 3 or greater than or equal to 4. The ink may be deposited onto the second major surface 480 (or a primer layer or other coating disposed thereon) using a suitable deposition process (e.g., inkjet printing or screen printing). After curing via a suitable curing method, the opaque layer 500 may comprise an average optical transmission of less than or equal to 1% (e.g., less than or equal to 0.5%, less than or equal to 0.1%) for light from 400 nm to 700 nm.

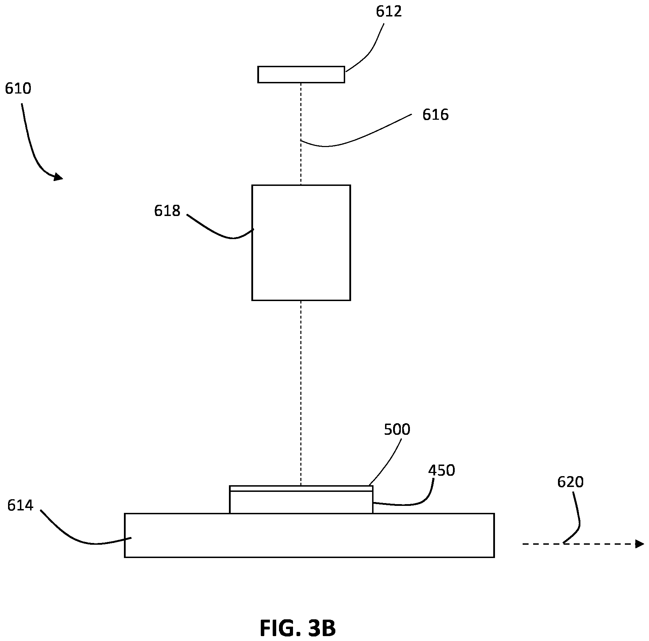

At block 604, the opaque layer 500 is exposed to light from a light source to selectively remove the opaque layer in a pattern to form transmissive regions in the opaque layer 500. In embodiments, portions of the opaque layer 500 are selectively exposed to a laser beam such that the laser beam heats the material of the opaque layer 500 to ablate the material and form the plurality of ablated portions 562. FIG. 3B schematically depicts an apparatus 610 that may be used to form the plurality of ablated portions 562. The apparatus 610 comprises a laser source 612 and a base 614. The laser source 612 is a laser system that emits a laser beam 616 at a suitable wavelength and intensity such that that the laser beam 616 is capable of ablating the material of the opaque layer 500. As described herein, the opaque layer 500 may be formed of a black or gray ink that exhibits a relatively high absorbance for light spanning from the UV to IR spectrums (e.g., from 300 nm to 10,000 nm). For example, in embodiments, the opaque layer 500 may be constructed of a suitable ink such as an epoxy-based ink, an acrylic-based ink, a latex-based ink, or a polyurethane-based ink that comprises an average absorbance of at least 99% for light from 400 nm to 700 nm. Commercially available laser sources may be used to emit light that can ablate the material of the opaque layer 500. Use of UV lasers (e.g., emitting a laser beam 616 having a linewidth including 355 nm), CO₂ lasers (e.g., emitting a laser beam 616 having a linewidth including 9.3 µm), and IR lasers (e.g., emitting a laser beam 616 having a linewidth including 1.06 µm) are contemplated and within the scope of the present disclosure. Such wavelengths are beneficial in that, with proper optical system configuration, they can be used without damaging the glass substrate 450.

A variety of approaches for forming the array of ablated portions 564 is contemplated. For example, in embodiments, the base 614 is stationary. As a result, the glass substrate 450, when placed on the base 614, may remain stationary upon exposure to the laser beam 616. Accordingly, to form ablated portions in a desired pattern, the laser beam 616 may be scanned over the opaque layer 500 such that various regions thereof are exposed to the laser beam 616 for a sufficient period to cause ablation of the material of the opaque layer 500. In this regard, the apparatus 610 may include an optical system 618. The optical system 618 may include one or more optical elements (e.g., lenses, mirrors, etc.) to manipulate the laser beam 616 and scan the opaque layer 500 in a desired pattern to form the array of ablated portions 564. For example, in embodiments, the optical system 618 comprises a galvanometric scanner (e.g., a 1D optical scanner, a 2D optical scanner) that alters the propagation direction of the laser beam 616 to change the point of incidence of the laser beam 616 on the opaque layer 500. In embodiments, for example, the laser beam 616 may initially be incident on a first portion of the opaque layer 500. The opaque layer 500 may be exposed to the laser beam 616 for an exposure period to cause sufficient heating to ablate the material of the opaque layer 500. After the exposure period, the galvanometric scanner may alter configurations to change the point of incidence of the laser beam 616 to form another ablated portion. Such a process may repeat until a desired pattern of ablated portions is formed.

In embodiments, the base 614 is in motion while the glass substrate 450 is exposed to the laser beam 616. For example, the base 614 may be (or disposed on) a conveyor belt that moves the glass substrate 450 in a conveyor direction 620. In such embodiments, a controller (not depicted) may detect the position of the glass substrate 450 and fire the laser source 612 to remove portions of the opaque layer 500 as described above. The scanning patterns of the laser beam 616 may be modified based on the movement rate and direction of the glass substrate 450. Such an "on the fly" approach beneficially improves operating efficiencies by avoiding stoppages of the glass substrate 450.

In embodiments, the optical system 618 also includes beam conditioning optics that may manipulate the spatial intensity distribution of the laser beam 616 when the laser beam 616 is incident on the opaque layer 500. For example, the optical system 618 may focus the laser beam 616 to cause at least a portion of the beam to have an intensity above an ablation threshold of the material of the opaque layer 500. The optical system 618 may also partially determine the shape of the ablated portions my manipulating the shape of the intensity distribution of the laser beam 616.

In embodiments, the optical system 618 may manipulate the laser beam 616 during the formation of a single one of the plurality of ablated portions 562. That is, during the formation of a single ablated portion, the optical system 618 may alter a point of incidence of the laser beam 616 on the opaque layer 500, such that each individual of ablated portion is formed by scanning the laser beam 616 in a scanning pattern. Such an approach provides flexibility in the shape and size of the ablated portion that may be formed, as the scanning pattern used may alter the precise portion of the opaque layer 500 that is exposed to enough radiation to cause ablation. Using such an approach, a wide variety of ablated portions, that may vary in shape from a spatial intensity distribution of the laser beam 616, may be formed. Ablated portions of circular, elliptical, and parallelepiped-shaped cross-sections are contemplated and within the scope of the present disclosure.

In embodiments, the optical system 618 can comprise one or more diffractive optical elements. For example, in embodiments, the diffractive optical element is a one-dimensional or two-dimensional diffractive beam splitter that can diffract the laser beam 616 into a plurality of diffractive beams that are each capable of ablating the material of the opaque layer 500. This way, a pattern of ablated regions can be formed via diffraction and without scanning the laser beam 616. In embodiments, the optical system 618 can include a micro lens array for focusing the laser beam 616 into a plurality of focal spots on the opaque layer 500 to form the array of ablated portions 652 without moving. Each focal spot may have a circular or non-circular spatial power distribution to facilitate forming ablated portions of a desired shape.

In embodiments, the optical system 618 can comprise of a geometrical phase hologram, a spatial light modulator, or other suitable beam manipulation device. In embodiments, for example, the hologram or spatial light modulator may be used in combination with a suitable optical system (e.g., lens system) to generate a desired pattern on the opaque layer 500 to form a pattern of ablated regions without any moving parts. Embodiments are also envisioned where the spatial light modulator, hologram, diffractive optical element(s), or micro lens array may be used in combination with a scanner to provide further flexibility in pattern generation.

Referring generally to FIG. 3B, it has been found that the laser source 612 may be operated to generate a pulsed or continuous wave laser beam and still successfully generate ablated portions in the opaque region in accordance with the present disclosure. In embodiments, for example, the laser source 612 may be operated as a quasi-cw laser, where the pump of a cw laser source is switched on for an interval determined to be sufficient to ablate the opaque layer 500 in a desired manner (e.g., less than or equal to 0.5 ms, less than or equal to 0.4 ms, less than or equal to 0.3 ms, less than or equal to 0.2 ms, less than or equal to 0.1 ms). In an example, a CO₂ laser operating at 9.3 µm with a Gaussian intensity distribution was operated to form ablated portions in an acrylic opaque layer. The laser was focused to a beam size (1/e²) at the focal point of about 80 µm. When the laser was operated using an on-interval of 0.1 ms for each ablated portion at a power of 4 W, an ablated portion with a maximum horizontal dimension of 65 µm was observed. In another example, a pulsed UV laser operating at 355 nm was used to generate ablated portions in an acrylic opaque layer. The pulse duration was 20 ns with a 60 kHz repetition rate. The UV laser had a Gaussian intensity distribution and was focused using a lens to a spot size of 25 µm. In embodiments, the laser can be defocused on the glass (e.g., by 10 mm or less, by 5 mm or less, 4 mm or less, 3 mm or less), such that the minimum spot size observed at the focal point was displaced from the second major surface 480. When the laser was defocused by 4 mm and had a power of 1.8 Watts, exposure of an area of 30 pulses resulted in a hole of 65 µm, with the opaque layer fully removed. As such, depending on how the laser beam 616 is focused via the optical system 618 ablated portions of various sizes may be formed using a variety of laser systems. The size of the ablated portions may also be varied depending on the exposure period (e.g., number of pulses or time period) for each portion of the opaque layer. Various combinations of laser sources and optical systems are contemplated and within the scope of the present disclosure.

Referring again to FIG. 3A, at block 606, the glass substrate 450 is positioned relative to the sensor 150 such that light propagating through the glass substrate 450 is transmitted through the plurality of ablated portions 562 onto the sensor 150. In embodiments, the sensor 150 is attached to the opaque layer 500 (e.g., via a suitable optically clear adhesive) such that the sensor 150 at least partially overlaps the sensor region 560 containing the array of ablated portions 564. In embodiments, the sensor 150 is positioned in the vehicle display system 100 when the display 110 is incorporated into the vehicle display system 100 and positioned on an optical path such that at least some light propagating through the sensor region 560 is incident on the sensor 150. In an example, the display module 540 is laminated to the glass substrate 450 as shown in FIG. 2B. The glass article 400 may then be attached to a support structure (not depicted) for mounting into the vehicle display system 100. As described herein, the ablated portions in the opaque layer 500 beneficially allow operation of the sensor 150 while hiding the sensor 150 from view.

It should be appreciated that display articles in accordance with the present disclosure may include any number of sensor regions. In embodiments, each of such sensor regions comprises a different array of ablated portions of the opaque layer 500. The arrays of ablated portions may vary depending on the sensors that each sensor region is disposed in front of. Embodiments are also envisioned where a single sensor region is placed in front of multiple sensors. A single array of ablated portions may be used to facilitate operation of a plurality of sensors while hiding the sensors from view.

### Examples

Embodiments of the present disclosure may be further understood in view of the following examples.

In the following examples, an opaque layer of a commercially available ink was disposed on a glass substrate and exposed to various lasers to form ablated portions as shown. In the examples, an acrylic opaque layer within the thickness ranges described herein was disposed on a glass substrate and subjected to exposure from various laser sources to generate the depicted ablated regions.

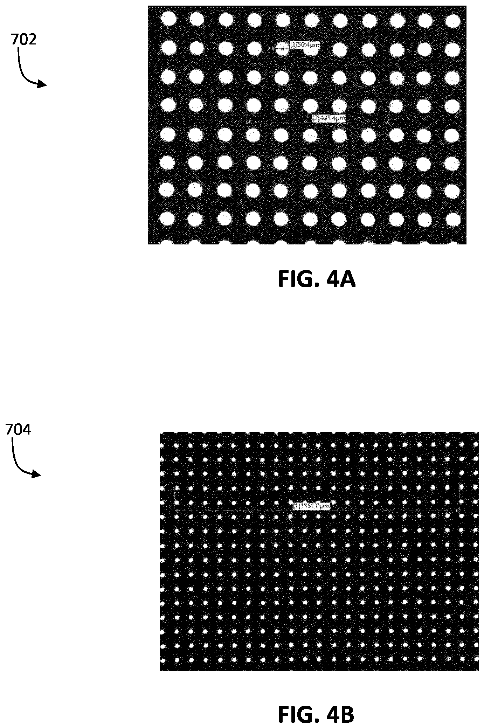

In a first example, a CO₂ laser operating at a 9.3 µm wavelength having an effective power of 4W was scanned over the opaque layer and used to generate circle-shaped holes in the opaque layer in a grid-like pattern (uniform spacing). The laser had a Gaussian intensity distribution and was focused onto the opaque layer with a spot size of about 80 µm. The laser was operated as a quasi-cw source with an on-time of 0.1 ms per ablated portion. Such an approach successfully generated ablated portions where the opaque layer was fully removed. The holes were 60 µm in diameter and a 20x20 grid was generated in less than 0.5 seconds. FIG. 4A depicts another example array of ablated portions 702 formed in the opaque layer with a CO₂ laser at 9.3 µm and a power of 2.6 W. As shown, the ablated portions were holes having a 50.4 µm diameter. The minimum edge-to-edge spacing of the holes was 48.7 µm. As such, the diameter of the holes was approximately equal to the minimum edge-to-edge distance in this example. The average optical transmission of ambient light for this example was calculated to be about 20%, without taking into account the surface reflections (about 4% in the visible).

FIG. 4B depicts another example array of ablated portions 704 formed by scanning a UV laser at 355 nm over the opaque layer. The laser was running at a 40 kHz repetition rate (with a pulse width of 20 ns) and with a power of 0.75W. The laser beam was focused on the opaque layer with a theoretical spot size (1/e²) of 25 µm. The laser beam was scanned in a grid pattern (line-by-line) stopping at a desired location to expose the opaque layer to a total of 4 pulses at each location to remove the opaque layer. The laser generated ablated portions that were circular holes with a diameter of 20 µm. The edge-to-edge spacing of the holes was measured to be about 77.5 µm, or more than three times the hole diameter. Such a structure resulted in a calculated optical transmission of about 5% for ambient light. The Examples described herein with respect to FIGS. 4A and 4B demonstrate how hole size and spacing may be used to determine the transmission of the glass article within the sensor region.

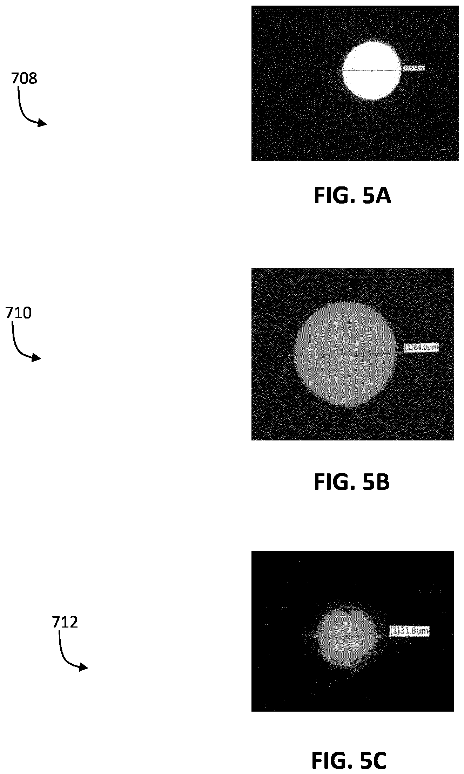

FIGS 5A, 5B, and 5C depict close-up images of ablated portions formed with different lasers. FIG. 5A shows a first ablated portion 708 having a diameter of 66.3 µm generated via exposure to a CO₂ laser at 9.3 µm. The laser power was 4.6 W. The laser was turned on and a circular scan with a radius of 1 µm and a speed of 50 mm/s was used to make the ablated hole. FIG. 5B shows a second ablated portion 710 having a diameter of 64.0 µm via exposure to a UV laser at 355 nm. The laser power was running at 2 W with a repetition rate of 60 kHz. The laser beam was focused on the opaque ink layer with a theoretical beam size of 25 um (1/e²). The laser was scanned at a speed of 400 mm/s along two concentric circles to remove the opaque ink layer. The concentric circles had radii of about 32 µm and 16 µm, respectively. FIG. 5C shows a third ablated portion 712 having a diameter of 31.8 µm generated via exposure to an IR laser at 1.06 µm. As shown, the third ablated portion 712 comprised a rougher edge than either of the first and second ablated portions 708 and 710. It is thought that this was due to variations in shape of the IR laser, or a reduced absorptivity of opaque layer at 1.06 µm. These examples demonstrate successful formation of ablated portions using a variety of commercially available lasers. Moreover, these examples also demonstrate how each individual ablated portion may be formed using a combination of scanning patterns (e.g., scanning the laser beam in one or more circles to generate each ablated portion) such that ablated portions with any desired shape may be formed. The scanning rate needed to ablate the opaque layer may depend on the power of the laser source and whether the laser source is pulsed or cw.

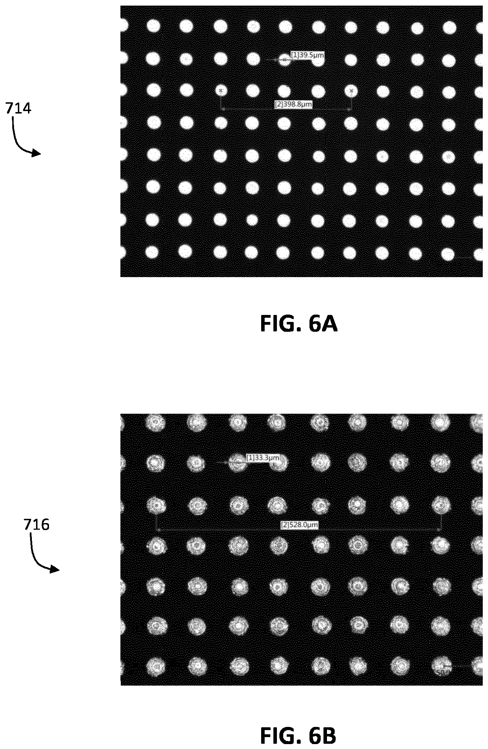

FIG. 6A depicts another example array of ablated portions 714 in an opaque layer. FIG. 6B depicts another example array of ablated portions 716 in an opaque layer. The ablated portions in both examples were formed using a CO₂ laser. The ablated portions in FIG. 6A comprised holes in the opaque layer where material of the opaque layer was completely removed (such that no material of the opaque layer was present within each ablated portion). The holes had a diameter of 39.5 µm and a minimum edge-to-edge distance of 60.2 µm. The ablated portions in FIG. 6B comprised holes in the opaque layer where the material of the opaque layer was only partially removed. That is, in FIG. 6B, some material of the opaque layer remained in each of the ablated portions so that the ablated portions have a similar appearance to the rest of the opaque layer. Such a structure may aid in hiding various sensors. The ablated portions in FIG. 6B comprise shallow pits of removed material of the opaque layer. The pits were circular and had a diameter of 33.3, with a minimum edge-to-edge spacing of 42.1 µm. In FIG. 6A, the laser was operated using a power of 2W and an on-time of 0.1 ms for each ablated portion. The ablation process was repeated 4 additional times with a separation of about 0.5 seconds to completely remove the opaque layer in each ablated portion. In FIG. 6B, the laser power was 1.8 W. The laser was turned on for 0.1 ms. This was repeated about 14 times, with a separation of 7.5 seconds between on-times. Such increased separation between on-times resulted in the ablation threshold being barely reached, such that the opaque layer was not completely removed. These examples demonstrate how laser operating parameters (laser power, pulse duration, number of pulses, pulse separation) may be slightly varied to control the amount of ink removal to change the visibility of any sensors and to change optical transmission performance.

### Glass Materials

Referring to FIG. 7, in embodiments the glass substrate 450 has a thickness t that is substantially constant over the width and length of the glass substrate 450 and is defined as a distance between the first major surface 470 and the second major surface 480. In various embodiments, T may refer to an average thickness or a maximum thickness of the glass substrate 450. In addition, the glass substrate 450 includes a width W defined as a first maximum dimension of one of the first or second major surfaces 470, 480 orthogonal to the thickness t, and a length L defined as a second maximum dimension of one of the first or second major surfaces 470, 480 orthogonal to both the thickness and the width. In other embodiments, W and L may be the average width and the average length of the glass substrate 450, respectively, and in other embodiments, W and L may be the maximum width and the maximum length of the glass substrate 450, respectively (e.g., for glass substrates 450 having a variable width or length).

In various embodiments, thickness t is 2 mm or less. In particular, the thickness t is from 0.30 mm to 2.0 mm. For example, thickness t may be in a range from about 0.30 mm to about 2.0 mm, from about 0.40 mm to about 2.0 mm, from about 0.50 mm to about 2.0 mm, from about 0.60 mm to about 2.0 mm, from about 0.70 mm to about 2.0 mm, from about 0.80 mm to about 2.0 mm, from about 0.90 mm to about 2.0 mm, from about 1.0 mm to about 2.0 mm, from about 1.1 mm to about 2.0 mm, from about 1.2 mm to about 2.0 mm, from about 1.3 mm to about 2.0 mm, from about 1.4 mm to about 2.0 mm, from about 1.5 mm to about 2.0 mm, from about 0.30 mm to about 1.9 mm, from about 0.30 mm to about 1.8 mm, from about 0.30 mm to about 1.7 mm, from about 0.30 mm to about 1.6 mm, from about 0.30 mm to about 1.5 mm, from about 0.30 mm to about 1.4 mm, from about 0.30 mm to about 1.4 mm, from about 0.30 mm to about 1.3 mm, from about 0.30 mm to about 1.2 mm, from about 0.30 mm to about 1.1 mm, from about 0.30 mm to about 1.0 mm, from about 0.30 mm to about 0.90 mm, from about 0.30 mm to about 0.80 mm, from about 0.30 mm to about 0.70 mm, from about 0.30 mm to about 0.60 mm, or from about 0.30 mm to about 0.40 mm. In other embodiments, the t falls within any one of the exact numerical ranges set forth in this paragraph.

In various embodiments, width W is in a range from 5 cm to 250 cm, from about 10 cm to about 250 cm, from about 15 cm to about 250 cm, from about 20 cm to about 250 cm, from about 25 cm to about 250 cm, from about 30 cm to about 250 cm, from about 35 cm to about 250 cm, from about 40 cm to about 250 cm, from about 45 cm to about 250 cm, from about 50 cm to about 250 cm, from about 55 cm to about 250 cm, from about 60 cm to about 250 cm, from about 65 cm to about 250 cm, from about 70 cm to about 250 cm, from about 75 cm to about 250 cm, from about 80 cm to about 250 cm, from about 85 cm to about 250 cm, from about 90 cm to about 250 cm, from about 95 cm to about 250 cm, from about 100 cm to about 250 cm, from about 110 cm to about 250 cm, from about 120 cm to about 250 cm, from about 130 cm to about 250 cm, from about 140 cm to about 250 cm, from about 150 cm to about 250 cm, from about 5 cm to about 240 cm, from about 5 cm to about 230 cm, from about 5 cm to about 220 cm, from about 5 cm to about 210 cm, from about 5 cm to about 200 cm, from about 5 cm to about 190 cm, from about 5 cm to about 180 cm, from about 5 cm to about 170 cm, from about 5 cm to about 160 cm, from about 5 cm to about 150 cm, from about 5 cm to about 140 cm, from about 5 cm to about 130 cm, from about 5 cm to about 120 cm, from about 5 cm to about 110 cm, from about 5 cm to about 110 cm, from about 5 cm to about 100 cm, from about 5 cm to about 90 cm, from about 5 cm to about 80 cm, or from about 5 cm to about 75 cm. In other embodiments, W falls within any one of the exact numerical ranges set forth in this paragraph.

In various embodiments, length L is in a range from about 5 cm to about 2500 cm, from about 5 cm to about 2000 cm, from about 4 to about 1500 cm, from about 50 cm to about 1500 cm, from about 100 cm to about 1500 cm, from about 150 cm to about 1500 cm, from about 200 cm to about 1500 cm, from about 250 cm to about 1500 cm, from about 300 cm to about 1500 cm, from about 350 cm to about 1500 cm, from about 400 cm to about 1500 cm, from about 450 cm to about 1500 cm, from about 500 cm to about 1500 cm, from about 550 cm to about 1500 cm, from about 600 cm to about 1500 cm, from about 650 cm to about 1500 cm, from about 650 cm to about 1500 cm, from about 700 cm to about 1500 cm, from about 750 cm to about 1500 cm, from about 800 cm to about 1500 cm, from about 850 cm to about 1500 cm, from about 900 cm to about 1500 cm, from about 950 cm to about 1500 cm, from about 1000 cm to about 1500 cm, from about 1050 cm to about 1500 cm, from about 1100 cm to about 1500 cm, from about 1150 cm to about 1500 cm, from about 1200 cm to about 1500 cm, from about 1250 cm to about 1500 cm, from about 1300 cm to about 1500 cm, from about 1350 cm to about 1500 cm, from about 1400 cm to about 1500 cm, or from about 1450 cm to about 1500 cm. In other embodiments, L falls within any one of the exact numerical ranges set forth in this paragraph.

In embodiments, the substrate 450, may be formed from any suitable glass composition comprising soda lime glass, aluminosilicate glass, borosilicate glass, boroaluminosilicate glass, alkali-containing aluminosilicate glass, alkali-containing borosilicate glass, and alkali-containing boroaluminosilicate glass.

Unless otherwise specified, the glass compositions disclosed herein are described in mole percent (mol%) as analyzed on an oxide basis.

In one or more embodiments, the glass composition may comprise SiO₂ in an amount in a range from about 66 mol% to about 80 mol%, from about 67 mol% to about 80 mol%, from about 68 mol% to about 80 mol%, from about 69 mol% to about 80 mol%, from about 70 mol% to about 80 mol%, from about 72 mol% to about 80 mol%, from about 65 mol% to about 78 mol%, from about 65 mol% to about 76 mol%, from about 65 mol% to about 75 mol%, from about 65 mol% to about 74 mol%, from about 65 mol% to about 72 mol%, or from about 65 mol% to about 70 mol%, and all ranges and sub-ranges therebetween.

In one or more embodiments, the glass composition comprises Al₂O₃ in an amount greater than about 4 mol%, or greater than about 5 mol%. In one or more embodiments, the glass composition comprises Al₂O₃ in a range from greater than about 7 mol% to about 15 mol%, from greater than about 7 mol% to about 14 mol%, from about 7 mol% to about 13 mol%, from about 4 mol% to about 12 mol%, from about 7 mol% to about 11 mol%, from about 8 mol% to about 15 mol%, from 9 mol% to about 15 mol%, from about 9 mol% to about 15 mol%, from about 10 mol% to about 15 mol%, from about 11 mol% to about 15 mol%, or from about 12 mol% to about 15 mol%, and all ranges and sub-ranges therebetween. In one or more embodiments, the upper limit of Al₂O₃ may be about 14 mol%, 14.2 mol%, 14.4 mol%, 14.6 mol%, or 14.8 mol%.

In one or more embodiments, glass layer(s) herein are described as an aluminosilicate glass article or comprising an aluminosilicate glass composition. In such embodiments, the glass composition or article formed therefrom comprises SiO₂ and Al₂O₃ and is not a soda lime silicate glass. In this regard, the glass composition or article formed therefrom comprises Al₂O₃ in an amount of about 2 mol% or greater, 2.25 mol% or greater, 2.5 mol% or greater, about 2.75 mol% or greater, about 3 mol% or greater.

In one or more embodiments, the glass composition comprises B₂O₃ (e.g., about 0.01 mol% or greater). In one or more embodiments, the glass composition comprises B₂O₃ in an amount in a range from about 0 mol% to about 5 mol%, from about 0 mol% to about 4 mol%, from about 0 mol% to about 3 mol%, from about 0 mol% to about 2 mol%, from about 0 mol% to about 1 mol%, from about 0 mol% to about 0.5 mol%, from about 0.1 mol% to about 5 mol%, from about 0.1 mol% to about 4 mol%, from about 0.1 mol% to about 3 mol%, from about 0.1 mol% to about 2 mol%, from about 0.1 mol% to about 1 mol%, from about 0.1 mol% to about 0.5 mol%, and all ranges and sub-ranges therebetween. In one or more embodiments, the glass composition is substantially free of B₂O₃.

As used herein, the phrase "substantially free" with respect to the components of the composition means that the component is not actively or intentionally added to the composition during initial batching, but may be present as an impurity in an amount less than about 0.001 mol%.

In one or more embodiments, the glass composition optionally comprises P₂O₅ (e.g., about 0.01 mol% or greater). In one or more embodiments, the glass composition comprises a non-zero amount of P₂O₅ up to and comprising 2 mol%, 1.5 mol%, 1 mol%, or 0.5 mol%. In one or more embodiments, the glass composition is substantially free of P₂O₅.

In one or more embodiments, the glass composition may comprise a total amount of R₂O (which is the total amount of alkali metal oxide such as Li₂O, Na₂O, K₂O, Rb₂O, and Cs₂O) that is greater than or equal to about 8 mol%, greater than or equal to about 10 mol%, or greater than or equal to about 12 mol%. In some embodiments, the glass composition comprises a total amount of R₂O in a range from about 8 mol% to about 20 mol%, from about 8 mol% to about 18 mol%, from about 8 mol% to about 16 mol%, from about 8 mol% to about 14 mol%, from about 8 mol% to about 12 mol%, from about 9 mol% to about 20 mol%, from about 10 mol% to about 20 mol%, from about 11 mol% to about 20 mol%, from about 12 mol% to about 20 mol%, from about 13 mol% to about 20 mol%, from about 10 mol% to about 14 mol%, or from 11 mol% to about 13 mol%, and all ranges and sub-ranges therebetween. In one or more embodiments, the glass composition may be substantially free of Rb₂O, Cs₂O or both Rb₂O and Cs₂O. In one or more embodiments, the R₂O may comprise the total amount of Li₂O, Na₂O and K₂O only. In one or more embodiments, the glass composition may comprise at least one alkali metal oxide selected from Li₂O, Na₂O and K₂O, wherein the alkali metal oxide is present in an amount greater than about 8 mol% or greater.

In one or more embodiments, the glass composition comprises Na₂O in an amount greater than or equal to about 8 mol%, greater than or equal to about 10 mol%, or greater than or equal to about 12 mol%. In one or more embodiments, the composition comprises Na₂O in a range from about from about 8 mol% to about 20 mol%, from about 8 mol% to about 18 mol%, from about 8 mol% to about 16 mol%, from about 8 mol% to about 14 mol%, from about 8 mol% to about 12 mol%, from about 9 mol% to about 20 mol%, from about 10 mol% to about 20 mol%, from about 11 mol% to about 20 mol%, from about 12 mol% to about 20 mol%, from about 13 mol% to about 20 mol%, from about 10 mol% to about 14 mol%, or from 11 mol% to about 16 mol%, and all ranges and sub-ranges therebetween.

In one or more embodiments, the glass composition comprises less than about 4 mol% K₂O, less than about 3 mol% K₂O, or less than about 1 mol% K₂O. In some instances, the glass composition may comprise K₂O in an amount in a range from about 0 mol% to about 4 mol%, from about 0 mol% to about 3.5 mol%, from about 0 mol% to about 3 mol%, from about 0 mol% to about 2.5 mol%, from about 0 mol% to about 2 mol%, from about 0 mol% to about 1.5 mol%, from about 0 mol% to about 1 mol%, from about 0 mol% to about 0.5 mol%, from about 0 mol% to about 0.2 mol%, from about 0 mol% to about 0.1 mol%, from about 0.5 mol% to about 4 mol%, from about 0.5 mol% to about 3.5 mol%, from about 0.5 mol% to about 3 mol%, from about 0.5 mol% to about 2.5 mol%, from about 0.5 mol% to about 2 mol%, from about 0.5 mol% to about 1.5 mol%, or from about 0.5 mol% to about 1 mol%, and all ranges and sub-ranges therebetween. In one or more embodiments, the glass composition may be substantially free of K₂O.

In one or more embodiments, the glass composition is substantially free of Li₂O.

In one or more embodiments, the amount of Na₂O in the composition may be greater than the amount of Li₂O. In some instances, the amount of Na₂O may be greater than the combined amount of Li₂O and K₂O. In one or more alternative embodiments, the amount of Li₂O in the composition may be greater than the amount of Na₂O or the combined amount of Na₂O and K₂O.

In one or more embodiments, the glass composition may comprise a total amount of RO (which is the total amount of alkaline earth metal oxide such as CaO, MgO, BaO, ZnO and SrO) in a range from about 0 mol% to about 2 mol%. In some embodiments, the glass composition comprises a non-zero amount of RO up to about 2 mol%. In one or more embodiments, the glass composition comprises RO in an amount from about 0 mol% to about 1.8 mol%, from about 0 mol% to about 1.6 mol%, from about 0 mol% to about 1.5 mol%, from about 0 mol% to about 1.4 mol%, from about 0 mol% to about 1.2 mol%, from about 0 mol% to about 1 mol%, from about 0 mol% to about 0.8 mol%, from about 0 mol% to about 0.5 mol%, and all ranges and sub-ranges therebetween.

In one or more embodiments, the glass composition comprises CaO in an amount less than about 1 mol%, less than about 0.8 mol%, or less than about 0.5 mol%. In one or more embodiments, the glass composition is substantially free of CaO. In some embodiments, the glass composition comprises MgO in an amount from about 0 mol% to about 7 mol%, from about 0 mol% to about 6 mol%, from about 0 mol% to about 5 mol%, from about 0 mol% to about 4 mol%, from about 0.1 mol% to about 7 mol%, from about 0.1 mol% to about 6 mol%, from about 0.1 mol% to about 5 mol%, from about 0.1 mol% to about 4 mol%, from about 1 mol% to about 7 mol%, from about 2 mol% to about 6 mol%, or from about 3 mol% to about 6 mol%, and all ranges and sub-ranges therebetween.

In one or more embodiments, the glass composition comprises ZrO₂ in an amount equal to or less than about 0.2 mol%, less than about 0.18 mol%, less than about 0.16 mol%, less than about 0.15 mol%, less than about 0.14 mol%, less than about 0.12 mol%. In one or more embodiments, the glass composition comprises ZrO₂ in a range from about 0.01 mol% to about 0.2 mol%, from about 0.01 mol% to about 0.18 mol%, from about 0.01 mol% to about 0.16 mol%, from about 0.01 mol% to about 0.15 mol%, from about 0.01 mol% to about 0.14 mol%, from about 0.01 mol% to about 0.12 mol%, or from about 0.01 mol% to about 0.10 mol%, and all ranges and sub-ranges therebetween.

In one or more embodiments, the glass composition comprises SnO₂ in an amount equal to or less than about 0.2 mol%, less than about 0.18 mol%, less than about 0.16 mol%, less than about 0.15 mol%, less than about 0.14 mol%, less than about 0.12 mol%. In one or more embodiments, the glass composition comprises SnO2 in a range from about 0.01 mol% to about 0.2 mol%, from about 0.01 mol% to about 0.18 mol%, from about 0.01 mol% to about 0.16 mol%, from about 0.01 mol% to about 0.15 mol%, from about 0.01 mol% to about 0.14 mol%, from about 0.01 mol% to about 0.12 mol%, or from about 0.01 mol% to about 0.10 mol%, and all ranges and sub-ranges therebetween.

In one or more embodiments, the glass composition may comprise an oxide that imparts a color or tint to the glass articles. In some embodiments, the glass composition comprises an oxide that prevents discoloration of the glass article when the glass article is exposed to ultraviolet radiation. Examples of such oxides comprise, without limitation oxides of: Ti, V, Cr, Mn, Fe, Co, Ni, Cu, Ce, W, and Mo.

In one or more embodiments, the glass composition comprises Fe expressed as Fe₂O₃, wherein Fe is present in an amount up to (and comprising) about 1 mol%. In some embodiments, the glass composition is substantially free of Fe. In one or more embodiments, the glass composition comprises Fe₂O₃ in an amount equal to or less than about 0.2 mol%, less than about 0.18 mol%, less than about 0.16 mol%, less than about 0.15 mol%, less than about 0.14 mol%, less than about 0.12 mol%. In one or more embodiments, the glass composition comprises Fe₂O₃ in a range from about 0.01 mol% to about 0.2 mol%, from about 0.01 mol% to about 0.18 mol%, from about 0.01 mol% to about 0.16 mol%, from about 0.01 mol% to about 0.15 mol%, from about 0.01 mol% to about 0.14 mol%, from about 0.01 mol% to about 0.12 mol%, or from about 0.01 mol% to about 0.10 mol%, and all ranges and sub-ranges therebetween.

Where the glass composition comprises TiO₂, TiO₂ may be present in an amount of about 5 mol% or less, about 2.5 mol% or less, about 2 mol% or less or about 1 mol% or less. In one or more embodiments, the glass composition may be substantially free of TiO₂.

An exemplary glass composition comprises SiO₂ in an amount in a range from about 65 mol% to about 75 mol%, Al₂O₃ in an amount in a range from about 8 mol% to about 14 mol%, Na₂O in an amount in a range from about 12 mol% to about 17 mol%, K₂O in an amount in a range of about 0 mol% to about 0.2 mol%, and MgO in an amount in a range from about 1. 5 mol% to about 6 mol%. Optionally, SnO₂ may be comprised in the amounts otherwise disclosed herein.

### Strengthened Glass Properties

In one or more embodiments, the glass substrate 450 discussed herein may be formed from a strengthened glass sheet or article. In one or more embodiments, the glass articles used to form the layer(s) of the decorated glass structures discussed herein may be strengthened to comprise compressive stress that extends from a surface to a depth of compression (DOC). The compressive stress regions are balanced by a central portion exhibiting a tensile stress. At the DOC, the stress crosses from a positive (compressive) stress to a negative (tensile) stress.

In one or more embodiments, the glass articles used to form the layer(s) of the decorated glass structures discussed herein may be strengthened mechanically by utilizing a mismatch of the coefficient of thermal expansion between portions of the glass to create a compressive stress region and a central region exhibiting a tensile stress. In some embodiments, the glass article may be strengthened thermally by heating the glass to a temperature above the glass transition point and then rapidly quenching.

In one or more embodiments, the glass articles used to form the layer(s) of the decorated glass structures discussed herein may be chemically strengthening by ion exchange. In the ion exchange process, ions at or near the surface of the glass article are replaced by - or exchanged with - larger ions having the same valence or oxidation state. In those embodiments in which the glass article comprises an alkali aluminosilicate glass, ions in the surface layer of the article and the larger ions are monovalent alkali metal cations, such as Li+, Na+, K+, Rb+, and Cs+. Alternatively, monovalent cations in the surface layer may be replaced with monovalent cations other than alkali metal cations, such as Ag+ or the like. In such embodiments, the monovalent ions (or cations) exchanged into the glass article generate a stress.

Ion exchange processes are typically carried out by immersing a glass article in a molten salt bath (or two or more molten salt baths) containing the larger ions to be exchanged with the smaller ions in the glass article. It should be noted that aqueous salt baths may also be utilized. In addition, the composition of the bath(s) may comprise more than one type of larger ion (e.g., Na+ and K+) or a single larger ion. It will be appreciated by those skilled in the art that parameters for the ion exchange process, comprising, but not limited to, bath composition and temperature, immersion time, the number of immersions of the glass article in a salt bath (or baths), use of multiple salt baths, additional steps such as annealing, washing, and the like, are generally determined by the composition of the glass layer(s) of a decorated glass structure (comprising the structure of the article and any crystalline phases present) and the desired DOC and CS of the glass layer(s) of a decorated glass structure that results from strengthening.

Exemplary molten bath composition may comprise nitrates, sulfates, and chlorides of the larger alkali metal ion. Typical nitrates comprise KNO₃, NaNO₃, LiNO₃, NaSO₄ and combinations thereof. The temperature of the molten salt bath typically is in a range from about 380°C up to about 450°C, while immersion times range from about 15 minutes up to about 100 hours depending on the glass thickness, bath temperature and glass (or monovalent ion) diffusivity. However, temperatures and immersion times different from those described above may also be used.

In one or more embodiments, the glass articles used to form the layer(s) of the decorated glass may be immersed in a molten salt bath of 100% NaNO₃, 100% KNO₃, or a combination of NaNO₃ and KNO₃ having a temperature from about 370 °C to about 480 °C. In some embodiments, the glass layer(s) of a decorated glass may be immersed in a molten mixed salt bath comprising from about 5% to about 90% KNO₃ and from about 10% to about 95% NaNO₃. In one or more embodiments, the glass article may be immersed in a second bath, after immersion in a first bath. The first and second baths may have different compositions and/or temperatures from one another. The immersion times in the first and second baths may vary. For example, immersion in the first bath may be longer than the immersion in the second bath.

In one or more embodiments, the glass articles used to form the layer(s) of the decorated glass structures may be immersed in a molten, mixed salt bath comprising NaNO₃ and KNO₃ (e.g., 49%/51%, 50%/50%, 51%/49%) having a temperature less than about 420 °C (e.g., about 400 °C or about 380 °C). for less than about 5 hours, or even about 4 hours or less.

Ion exchange conditions can be tailored to provide a "spike" or to increase the slope of the stress profile at or near the surface of the resulting glass layer(s) of a decorated glass structure. The spike may result in a greater surface CS value. This spike can be achieved by single bath or multiple baths, with the bath(s) having a single composition or mixed composition, due to the unique properties of the glass compositions used in the glass layer(s) of a decorated glass structure described herein.

In one or more embodiments, where more than one monovalent ion is exchanged into the glass articles used to form the layer(s) of the decorated glass structures, the different monovalent ions may exchange to different depths within the glass layer (and generate different magnitudes stresses within the glass article at different depths). The resulting relative depths of the stress-generating ions can be determined and cause different characteristics of the stress profile.

CS is measured using those means known in the art, such as by surface stress meter (FSM) using commercially available instruments such as the FSM-6000, manufactured by Orihara Industrial Co., Ltd. (Japan). Surface stress measurements rely upon the accurate measurement of the stress optical coefficient (SOC), which is related to the birefringence of the glass. SOC in turn is measured by those methods that are known in the art, such as fiber and four point bend methods, both of which are described in ASTM standard C770-98 (2013), entitled "Standard Test Method for Measurement of Glass Stress-Optical Coefficient," and a bulk cylinder method. As used herein CS may be the "maximum compressive stress" which is the highest compressive stress value measured within the compressive stress layer. In some embodiments, the maximum compressive stress is located at the surface of the glass article. In other embodiments, the maximum compressive stress may occur at a depth below the surface, giving the compressive profile the appearance of a "buried peak."

DOC may be measured by FSM or by a scattered light polariscope (SCALP) (such as the SCALP-04 scattered light polariscope available from Glasstress Ltd., located in Tallinn Estonia), depending on the strengthening method and conditions. When the glass article is chemically strengthened by an ion exchange treatment, FSM or SCALP may be used depending on which ion is exchanged into the glass article. Where the stress in the glass article is generated by exchanging potassium ions into the glass article, FSM is used to measure DOC. Where the stress is generated by exchanging sodium ions into the glass article, SCALP is used to measure DOC. Where the stress in the glass article is generated by exchanging both potassium and sodium ions into the glass, the DOC is measured by SCALP, since it is believed the exchange depth of sodium indicates the DOC and the exchange depth of potassium ions indicates a change in the magnitude of the compressive stress (but not the change in stress from compressive to tensile); the exchange depth of potassium ions in such glass articles is measured by FSM. Central tension or CT is the maximum tensile stress and is measured by SCALP.

In one or more embodiments, the glass articles used to form the layer(s) of the decorated glass structures maybe strengthened to exhibit a DOC that is described a fraction of the thickness t of the glass article (as described herein). For example, in one or more embodiments, the DOC may be equal to or greater than about 0.05t, equal to or greater than about 0.1t, equal to or greater than about 0.11t, equal to or greater than about 0.12t, equal to or greater than about 0.13t, equal to or greater than about 0.14t, equal to or greater than about 0.15t, equal to or greater than about 0.16t, equal to or greater than about 0.17t, equal to or greater than about 0.18t, equal to or greater than about 0.19t, equal to or greater than about 0.2t, equal to or greater than about 0.21t. In some embodiments, The DOC may be in a range from about 0.08t to about 0.25t, from about 0.09t to about 0.25t, from about 0.18t to about 0.25t, from about 0.11t to about 0.25t, from about 0.12t to about 0.25t, from about 0.13t to about 0.25t, from about 0.14t to about 0.25t, from about 0.15t to about 0.25t, from about 0.08t to about 0.24t, from about 0.08t to about 0.23t, from about 0.08t to about 0.22t, from about 0.08t to about 0.21t, from about 0.08t to about 0.2t, from about 0.08t to about 0.19t, from about 0.08t to about 0.18t, from about 0.08t to about 0.17t, from about 0.08t to about 0.16t, or from about 0.08t to about 0.15t. In some instances, the DOC may be about 20 µm or less. In one or more embodiments, the DOC may be about 40 µm or greater (e.g., from about 40 µm to about 300 µm, from about 50 µm to about 300 µm, from about 60 µm to about 300 µm, from about 70 µm to about 300 µm, from about 80 µm to about 300 µm, from about 90 µm to about 300 µm, from about 100 µm to about 300 µm, from about 110 µm to about 300 µm, from about 120 µm to about 300 µm, from about 140 µm to about 300 µm, from about 150 µm to about 300 µm, from about 40 µm to about 290 µm, from about 40 µm to about 280 µm, from about 40 µm to about 260 µm, from about 40 µm to about 250 µm, from about 40 µm to about 240 µm, from about 40 µm to about 230 µm, from about 40 µm to about 220 µm, from about 40 µm to about 210 µm, from about 40 µm to about 200 µm, from about 40 µm to about 180 µm, from about 40 µm to about 160 µm, from about 40 µm to about 150 µm, from about 40 µm to about 140 µm, from about 40 µm to about 130 µm, from about 40 µm to about 120 µm, from about 40 µm to about 110 µm, or from about 40 µm to about 100 µm.

In one or more embodiments, the glass articles used to form the layer(s) of the decorated glass structures may have a CS (which may be found at the surface or a depth within the glass article) of about 200 MPa or greater, 300 MPa or greater, 400 MPa or greater, about 500 MPa or greater, about 600 MPa or greater, about 700 MPa or greater, about 800 MPa or greater, about 900 MPa or greater, about 930 MPa or greater, about 1000 MPa or greater, or about 1050 MPa or greater.

In one or more embodiments, the glass articles used to form the layer(s) of the decorated glass structures may have a maximum tensile stress or central tension (CT) of about 20 MPa or greater, about 30 MPa or greater, about 40 MPa or greater, about 45 MPa or greater, about 50 MPa or greater, about 60 MPa or greater, about 70 MPa or greater, about 75 MPa or greater, about 80 MPa or greater, or about 85 MPa or greater. In some embodiments, the maximum tensile stress or central tension (CT) may be in a range from about 40 MPa to about 100 MPa.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is in no way intended that any particular order be inferred. In addition, as used herein, the article "a" is intended to comprise one or more than one component or element, and is not intended to be construed as meaning only one.

It will be apparent to those skilled in the art that various modifications and variations can be made without departing from the scope of the disclosed embodiments. Since modifications, combinations, sub-combinations and variations of the disclosed embodiments incorporating the substance of the embodiments may occur to persons skilled in the art, the disclosed embodiments should be construed to comprise everything within the scope of the appended claims.

## Claims

1. A glass article (400) comprising:
a glass substrate (450) having a first major surface (470) and a second major surface (480), the second major surface (480) being opposite the first major surface (470); and
an opaque layer (500) disposed on the second major surface (480), wherein:
the opaque layer (500) comprises an optical density of greater than 3.0 such that portions of the glass substrate (450) covered by the opaque layer (500) comprise an average optical transmission of less than or equal to 0.5% for light from 400 nm to 700 nm,
within a sensor (150) region (460) of the glass article (400), the opaque layer (500) comprises a plurality of ablated portions (562), and
an average optical transmission of the glass article (400) within the sensor (150) region (460) is greater than or equal 1.0% and less than or equal to 20% for the light from 400 nm to 700 nm as a result of the plurality of ablated portions (562).

2. The glass article (400) of claim 1, wherein each of the plurality of ablated portions (562) is completely devoid of material making up a remainder of the opaque layer (500).

3. The glass article (400) of claim 1, wherein, within each of the plurality of ablated portions (562), a material of the opaque layer (500) is only partially removed such that the opaque layer (500) comprises at least some of the material in each of the plurality of ablated portions (562).

4. The glass article (400) of any of claims 1-3, wherein each of the plurality of ablated portions (562) comprises a maximum horizontal dimension (565), measured in a direction parallel to the second major surface (480), that is less than or equal to 100 µm.

5. The glass article (400) of claim 4, wherein adjacent ones of the plurality of ablated portions (562) are separated from one another by a minimum edge-to-edge separation distance (570, 572) that is greater than or equal to the maximum horizontal dimension (565).

6. The glass article (400) of any of claims 1-5, wherein a combined surface area of the plurality of ablated portions (562) constitutes no more than 50% of a total surface area of the sensor (150) region (460).

7. The glass article (400) of claim 6, wherein the combined surface area of the plurality of ablated portions (562) constitutes no more than 25% of the total surface area of the sensor (150) region (460).

8. The glass article (400) of any of claims 1-7, wherein the opaque layer (500) comprises a curable ink and comprises a thickness of less than or equal to 25 µm.

9. The glass article (400) of any of claims 1-8, wherein:
the opaque layer (500) comprises an edge that delineates a boundary between an image region that is not covered by the opaque layer (500) and a peripheral region of the glass article (400) that is covered by the opaque layer (500), and
the sensor (150) region (460) comprises a sub-region of the peripheral region.

10. The glass article (400) of claim 9, further comprising:
a sensor (150) positioned behind the glass substrate (450) such that light initially incident on the first major surface (470) propagates through the glass substrate (450) and through the plurality of ablated portions (562) prior to being incident on the sensor (150); and
a display module (540) positioned behind the glass substrate (450), wherein the display module (540) is controlled via the sensor (150).

11. The glass article (400) of claim 10, wherein the sensor (150) region (460) comprises an average optical transmission of greater than or equal to 5.0% and less than or equal to 20% for the light from 400 nm to 700 nm.

12. A method (600) of fabricating a glass article (400), the method (600) comprising:
forming (604) a plurality of ablated portions (562) in a sensor (150) region (460) of an opaque layer (500) disposed on a major surface of the glass substrate (450) by exposing the opaque layer (500) to a laser beam (616) to ablate material of the opaque layer (500), wherein:
the opaque layer (500) comprises an optical density of greater than 3.0 such that portions of the glass substrate (450) covered by the opaque layer (500) comprise an average optical transmission of less than or equal to 0.5% for light from 400 nm to 700 nm, and
an average optical transmission of the glass article (400) within the sensor (150) region (460) is greater than or equal 1.0% for the light from 400 nm to 700 nm as a result of the plurality of ablated portions (562).

13. The method (600) of claim 12, further comprising generating the laser beam (616) with a laser source (612), wherein the laser source (612) comprises a CO₂ laser, an ultraviolet laser, or an infrared laser.

14. The method (600) of any of claims 12-13, wherein the forming the plurality of ablated portions (562) comprises scanning the laser beam (616) in a scanning pattern over the sensor (150) region (460).

15. The method (600) of any of claims 12-14, wherein the glass substrate (450) is moving during the formation of the plurality of ablated portions (562).

## Patentansprüche

1. Glasartikel (400), aufweisend:
ein Glassubstrat (450) mit einer ersten Hauptfläche (470) und einer zweiten Hauptfläche (480), wobei die zweite Hauptfläche (480) entgegengesetzt zur ersten Hauptfläche (470) ist; und
eine opake Schicht (500), die auf der zweiten Hauptfläche (480) angeordnet ist, wobei:
die opake Schicht (500) eine optische Dichte von über 3,0 hat, so dass Abschnitte des Glassubstrats (450), die von der opaken Schicht (500) bedeckt sind, für Licht von 400 nm bis 700 nm eine mittlere optische Transmission von kleiner oder gleich 0,5 % aufweisen,
innerhalb eines Sensor-(150)-Bereichs (460) des Glasartikels (400) die opake Schicht (500) eine Vielzahl von abgetragenen Abschnitten (562) aufweist, und
eine mittlere optische Transmission des Glasartikels (400) innerhalb des Sensor-(150)-Bereichs (460) infolge der Vielzahl von abgetragenen Abschnitten (562) für Licht von 400 nm bis 700 nm größer oder gleich 1,0 % und kleiner oder gleich 20 % ist.

2. Glasartikel (400) nach Anspruch 1, wobei jeder aus der Vielzahl von abgetragenen Abschnitten (562) vollkommen frei von einem Material ist, das den Rest der opaken Schicht (500) ausmacht.

3. Glasartikel (400) nach Anspruch 1, wobei innerhalb von jedem aus der Vielzahl von abgetragenen Abschnitten (562) ein Material der opaken Schicht (500) nur teilweise entfernt ist, so dass die opake Schicht (500) zumindest einen Teil des Materials in jedem aus der Vielzahl von abgetragenen Abschnitten (562) aufweist.

4. Glasartikel (400) nach einem der Ansprüche 1 bis 3,
wobei jeder aus der Vielzahl von abgetragenen Abschnitten (562) eine maximale horizontale Abmessung (565) hat, gemessen in einer Richtung parallel zur zweiten Hauptfläche (480), die kleiner oder gleich 100 µm ist.

5. Glasartikel (400) nach Anspruch 4, wobei benachbarte Abschnitte aus der Vielzahl von abgetragenen Abschnitten (562) voneinander um einen minimalen, von Rand zu Rand reichenden Trennabstand (570, 572) voneinander getrennt sind, der größer oder gleich der maximalen horizontalen Abmessung (565) ist.

6. Glasartikel (400) nach einem der Ansprüche 1 bis 5, wobei ein kombinierter Flächeninhalt der Vielzahl von abgetragenen Abschnitten (562) nicht mehr als 50 % des Gesamtflächeninhalts des Sensor-(150)-Bereichs (460) bildet.

7. Glasartikel (400) nach Anspruch 6, wobei der kombinierte Flächeninhalt der Vielzahl von abgetragenen Abschnitten (562) nicht mehr als 25 % des Gesamtflächeninhalts des Sensor-(150)-Bereichs (460) bildet.

8. Glasartikel (400) nach einem der Ansprüche 1 bis 7,
wobei die opake Schicht (500) eine härtbare Tinte aufweist und eine Dicke von kleiner oder gleich 25 µm hat.

9. Glasartikel (400) nach einem der Ansprüche 1 bis 8, wobei:
die opake Schicht (500) einen Rand aufweist, der eine Grenze zwischen einem Bildbereich, der nicht von der opaken Schicht (500) bedeckt ist, und einem Umfangsbereich des Glasartikels (400) darstellt, der von der opaken Schicht (500) bedeckt ist, und
der Sensor-(150)-Bereich (460) einen Teilbereich des Umfangsbereichs aufweist.

10. Glasartikel (400) nach Anspruch 9, darüber hinaus aufweisend:
einen Sensor (150), der hinter dem Glassubstrat (450) positioniert ist, so dass Licht, das zunächst auf die erste Hauptfläche (470) fällt, sich durch das Glassubstrat (450) und durch die Vielzahl von abgetragenen Abschnitten (562) fortpflanzt, bevor es auf den Sensor (150) fällt; und
ein Anzeigemodul (540), das hinter dem Glassubstrat (450) positioniert ist, wobei das Anzeigemodul (540) vom Sensor (150) gesteuert wird.

11. Glasartikel (400) nach Anspruch 10, wobei der Sensor-(150)-Bereich (460) für Licht von 400 nm bis 700 nm eine mittlere optische Transmission von größer oder gleich 5,0 % und kleiner oder gleich 20 % hat.

12. Verfahren (600) zum Herstellen eines Glasartikels (400), wobei das Verfahren (600) umfasst:
Bilden (604) einer Vielzahl von abgetragenen Abschnitten (562) in einem Sensor-(150)-Bereich (460) einer opaken Schicht (500), die auf einer Hauptfläche des Glassubstrats (450) angeordnet ist, indem die opake Schicht (500) einem Laserstrahl (616) ausgesetzt wird, um Material der opaken Schicht (500) abzutragen, wobei:
die opake Schicht (500) eine optische Dichte von über 3,0 hat, so dass Abschnitte des Glassubstrats (450), die von der opaken Schicht (500) bedeckt sind, für Licht von 400 nm bis 700 nm eine mittlere optische Transmission von kleiner oder gleich 0,5 % aufweisen, und
eine mittlere optische Transmission des Glasartikels (400) innerhalb des Sensor-(150)-Bereichs (460) infolge der Vielzahl von abgetragenen Abschnitten (562) für Licht von 400 nm bis 700 nm größer oder gleich 1,0 % ist.

13. Verfahren (600) nach Anspruch 12, darüber hinaus umfassend, den Laserstrahl (616) mit einer Laserquelle (612) zu erzeugen, wobei die Laserquelle (612) einen CO₂-Laser, einen Ultraviolettlaser oder einen Infrarotlaser aufweist.

14. Verfahren (600) nach einem der Ansprüche 12 bis 13,
wobei das Bilden der Vielzahl von abgetragenen Abschnitten (562) umfasst, den Laserstrahl (616) in einem Abtastmuster über den Sensor-(150)-Bereich (460) zu führen.

15. Verfahren (600) nach einem der Ansprüche 12 bis 14, wobei sich das Glassubstrat (450) während der Bildung der Vielzahl von abgetragenen Abschnitten (562) bewegt.

## Revendications

1. Article en verre (400), comprenant :
un substrat en verre (450) ayant une première surface principale (470) et une deuxième surface principale (480), la deuxième surface principale (480) étant opposée à la première surface principale (470) ; et
une couche opaque (500) disposée sur la deuxième surface principale (480), sachant que :
la couche opaque (500) a une densité optique supérieure à 3,0, de sorte que des sections du substrat en verre (450) recouvertes par la couche opaque (500) aient une transmission optique moyenne inférieure ou égale à 0,5 % pour la lumière de 400 nm à 700 nm,
à l'intérieur d'une zone (460) de capteur (150) de l'article en verre (400), la couche opaque (500) comprend une pluralité de sections enlevées (562), et
la transmission optique moyenne de l'article en verre (400) dans la zone (460) de capteur (150) est supérieure ou égale à 1,0 % et inférieure ou égale à 20 % pour la lumière de 400 nm à 700 nm, en raison de la pluralité de sections enlevées (562).

2. L'article en verre (400) selon la revendication 1, sachant que chacun de la pluralité de sections enlevées (562) est totalement exempt du matériau constituant le reste de la couche opaque (500).

3. L'article en verre (400) selon la revendication 1, sachant qu'à l'intérieur de chacune de la pluralité de sections enlevées (562), un matériau de la couche opaque (500) n'est que partiellement enlevé, de sorte que la couche opaque (500) comprenne au moins une partie du matériau dans chacune de la pluralité de sections enlevées (562).

4. L'article en verre (400) selon l'une des revendications 1 à 3, sachant que chacune de la pluralité de sections enlevées (562) a une dimension horizontale maximale (565), mesurée dans une direction parallèle à la deuxième surface principale (480), qui est inférieure ou égale à 100 µm.

5. L'article en verre (400) selon la revendication 4,
sachant que des sections adjacentes de la pluralité de sections enlevées (562) sont séparées les unes des autres par une distance de séparation minimale (570, 572) s'étendant d'un bord à l'autre, qui est supérieure ou égale à la dimension horizontale maximale (565).

6. L'article en verre (400) selon l'une des revendications 1 à 5, sachant qu'une surface combinée de la pluralité de sections enlevées (562) ne représente pas plus de 50 % de la surface totale de la zone (460) de capteur (150).

7. L'article en verre (400) selon la revendication 6, sachant que la surface combinée de la pluralité de sections enlevées (562) ne représente pas plus de 25 % de la surface totale de la zone (460) de capteur (150).

8. L'article en verre (400) selon l'une des revendications 1 à 7, sachant que la couche opaque (500) comprend une encre durcissable et a une épaisseur inférieure ou égale à 25 µm.

9. L'article en verre (400) selon l'une des revendications 1 à 8, sachant que :
la couche opaque (500) comprend un bord constituant une démarcation entre une zone d'image non recouverte par la couche opaque (500) et une zone périphérique de l'article en verre (400) recouverte par la couche opaque (500), et
la zone (460) de capteur (150) comprend une zone partielle de la zone périphérique.

10. L'article en verre (400) selon la revendication 9, comprenant en outre :
un capteur (150) positionné derrière le substrat en verre (450) de sorte que la lumière atteignant d'abord la première surface principale (470) se propage à travers le substrat en verre (450) et à travers la pluralité de sections enlevées (562) avant d'atteindre le capteur (150) ; et
un module d'affichage (540) positionné derrière le substrat en verre (450), le module d'affichage (540) étant commandé par le capteur (150).

11. L'article en verre (400) selon la revendication 10, sachant que la zone (460) de capteur (150) a une transmission optique moyenne supérieure ou égale à 5,0 % et inférieure ou égale à 20 % pour la lumière de 400 nm à 700 nm.

12. Procédé (600) de fabrication d'un article en verre (400), le procédé (600) comprenant :
la formation (604) d'une pluralité de sections enlevées (562) dans une zone (460) de capteur (150) d'une couche opaque (500) disposée sur une surface principale du substrat en verre (450) en exposant la couche opaque (500) à un faisceau laser (616) pour enlever de la matière de la couche opaque (500), sachant que :
la couche opaque (500) a une densité optique supérieure à 3,0, de sorte que des sections du substrat en verre (450) recouvertes par la couche opaque (500) aient une transmission optique moyenne inférieure ou égale à 0,5 % pour la lumière de 400 nm à 700 nm, et
une transmission optique moyenne de l'article en verre (400) à l'intérieur de la zone (460) de capteur (150) est supérieure ou égale à 1,0 % pour la lumière de 400 nm à 700 nm, en raison de la pluralité de sections enlevées (562).

13. Le procédé (600) selon la revendication 12, comprenant en outre la génération du faisceau laser (616) au moyen d'une source laser (612), la source laser (612) comprenant un laser CO₂, un laser ultraviolet ou un laser infrarouge.

14. Le procédé (600) selon l'une des revendications 12 à 13, sachant que la formation de la pluralité de sections enlevées (562) comprend le guidage du faisceau laser (616) selon un motif de balayage sur la zone (460) de capteur (150).

15. Le procédé (600) selon l'une des revendications 12 à 14, sachant que le substrat en verre (450) se déplace pendant la formation de la pluralité de sections enlevées (562).
